(19) Europäisches Patentamt / European Patent Office / Office européen des brevets

(11) **EP 4 345 447 B1**

(12) **EUROPEAN PATENT SPECIFICATION**

(45) Date of publication and mention of the grant of the patent:
**25.03.2026 Bulletin 2026/13**

(21) Application number: **22199178.9**

(22) Date of filing: **30.09.2022**

(51) International Patent Classification (IPC):
**G01N 23/2251** (2018.01)     **H01J 37/26** (2006.01)

(52) Cooperative Patent Classification (CPC):
**G01N 23/2251; H01J 37/265;** G01N 2223/303;
G01N 2223/306; G01N 2223/33; G01N 2223/335;
G01N 2223/401; G01N 2223/418; H01J 2237/1501

(54) **A METHOD OF AUTOMATED DATA ACQUISITION FOR A TRANSMISSION ELECTRON MICROSCOPE**

VERFAHREN ZUR AUTOMATISIERTEN DATENERFASSUNG FÜR EIN TRANSMISSIONSELEKTRONENMIKROSKOP

PROCÉDÉ D'ACQUISITION DE DONNÉES AUTOMATISÉE POUR UN MICROSCOPE ÉLECTRONIQUE À TRANSMISSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**03.04.2024 Bulletin 2024/14**

(60) Divisional application:
**26152899.6 / 4 708 350**

(73) Proprietor: **FEI COMPANY**
**Hillsboro, OR 97124 (US)**

(72) Inventors:
- **DENG, Yuchen**
  **5602 B5 Eindhoven (NL)**
- **KOHR, Holger**
  **5602 B5 Eindhoven (NL)**
- **VAN KNIPPENBERG, Bart**
  **5602 B5 Eindhoven (NL)**
- **TIEMEIJER, Peter**
  **5602 B5 Eindhoven (NL)**
- **YU, Lingbo**
  **5602 B5 Eindhoven (NL)**

(74) Representative: **Boult Wade Tennant LLP**
**Salisbury Square House**
**8 Salisbury Square**
**London EC4Y 8AP (GB)**

(56) References cited:
- LIU JINXIN ET AL: "Fully Mechanically Controlled Automated Electron Microscopic Tomography", SCIENTIFIC REPORTS, vol. 6, no. 1, 11 July 2016 (2016-07-11), XP093032039, DOI: 10.1038/srep29231
- KEVIN M ROCCAPRIORE ET AL: "Identification and Correction of Temporal and Spatial Distortions in Scanning Transmission Electron Microscopy", ARXIV.ORG, CORNELL UNIVERSITY LIBRARY, 201 OLIN LIBRARY CORNELL UNIVERSITY ITHACA, NY 14853, 11 September 2020 (2020-09-11), XP091063645, DOI: 10.1016/J.ULTRAMIC.2021.113337
- VAN HORSSEN E.P. ET AL: "Image-based feedback control for drift compensation in an electron microscope", IFAC JOURNAL OF SYSTEMS AND CONTROL, vol. 11, no. 100074, 31 January 2020 (2020-01-31), pages 1 - 15, XP055945403, ISSN: 2468-6018, DOI: 10.1016/j.ifacsc.2020.100074

**Description**

**Field of the invention**

The invention relates to targeting methods for controlling a transmission electron microscope in order to perform automated data acquisition for single particle analysis (SPA) on a cryogenic electron microscope (cryo-EM). Specifically, the invention provides improved techniques for collecting high-magnification images via image shift processes.

**Background**

The invention relates to improving the beam control accuracy while imaging the target areas in SPA data acquisition.

*Description of the SPA sample:*

A typical SPA sample contains many bio-macromolecules of the same type frozen on a grid (mostly fabricated with copper or gold, ~3 millimeters in diameter). Such a grid normally contains ~500 meshes ("grid squares", squares with ~75 micrometers side length). Each such square contains a thin carbon foil with hundreds of regularly distributed holes of approximately 1 micrometer diameter (usually in the range of 0.2 to 2 micrometers). One suitable freezing method is plunge-freezing, which ensures that each such hole is covered by a thin layer of amorphous ice containing multiple bio-macromolecules. Other freezing methods, such as jet-freezing and print-based freezing are also possible.

*SPA data acquisition and the beam control scheme:*

SPA data acquisition is typically performed by:

(1) setting the microscope to a low magnification (LM) mode (typically 200-500 x);
(2) acquiring a navigation image ("grid square image") under the conditions of (1); typically, such navigation image spans about 10 to 100 micrometers;
(3) using the navigation image to identify and select a subset of foil holes as the target areas for data acquisition;
(4) switching to a high magnification (HM) mode (typically 20,000-100,000x);
(5) sequentially acquiring HM images of the biomolecules in the ice sheets at the locations of the foil holes; typically, such HM images span about 100 to 1000 nanometers. Multiple HM images may be recorded at a single foil hole, provided the foil is larger than the span of a HM image, and provided the illumination used to record HM images does not overlap with a next HM image (otherwise overlapping illuminating would cause radiation damage in the next HM image).

Here, "target area" means the area (typically a part of a selected ice foil or foil hole) that is to be captured on the camera at HM; "target position" or "target location" means the center position in the target area.

These locations can be visited by proper stage movements or by properly deflecting the electron beam using the beam deflection units of the electron microscope. The navigation image is used to determine the magnitudes and directions of the stage movements and/or electron beam deflections that are needed to center the HM images at the selected subset of foil holes.

Usually, such electron beam deflection consists of two simultaneous and synchronous actions: a deflection above the sample and a deflection below the sample. The combined effect of these two deflections is that the part of the sample that is imaged on the camera is shifted away from the optical axis (thus effectively mimicking a mechanical movement of the sample), and therefore such electron beam deflection is usually called an "image shift". However, since the range of electron beam deflection is limited to several tens of micrometers from the optical axis ("off-axis") in current microscopes, sample stage movement is required to perform larger moves.

The beam deflection is usually preferred whenever possible, since moving the sample stage mechanically is much slower and introduces undesirable mechanical drift that may lead to loss of resolution in recorded images.

One example of existing methods for collecting large sets of SPA images is the EPU ('E Pluribus Unum') software from Thermo Fisher Scientific, which includes image shift techniques. These image shift techniques allow collection of image data from off-axis foil holes without moving the stage to bring those foil holes closer to the optical axis of the objective lens. As a result, the number of stage moves required to image predefined locations on a grid square can be reduced. Optical aberrations resulting from these image shift techniques can be minimized by simultaneous re-focusing of the objective lens, simultaneous re-stigmating the image, and simultaneous applying proper tilt of the illuminating beam.

The aforementioned image shift is achieved by adjusting the current of the deflectors (the optical modules that achieve beam deflection) in the microscope column. The relation between the set current and the observed image shift at the specimen is theoretically linear and is modeled in the image shift control logic.

However, image shifts applied by this control logic sometimes do not shift the beam accurately to the pre-selected ice holes. In other words, there can be a mismatch between the positions of the ice holes as measured from the navigation image and the positions of the ice holes as expressed in currents applied to deflector coils. These mismatches are usually referred to as "targeting errors". Targeting errors can happen especially when the required image shifts are relatively large (e.g., larger than 12 micrometer). Inventors hypothesized and identified that such errors can originate from the following linear and/or non-linear contributions to the navigation image and to the shifts observed at the sample:

(1) distortions in the navigation image or in the HM images; these distortions can be due to optical aberrations that are inherent to electron microscope's lenses, such as third-order image distortions, but these distortions can also be due to optical aberrations that are a result of mechanical imperfections, such as slight non-roundness or slight shifts of the lenses of the electron microscope.

(2) local deviations of the sample height from the optical plane which the microscope images on the image detector; such a deviation, especially in combination with tilt of the illuminating beam, can lead to a difference between the position of the sample that was intended to be imaged on the camera, and the position of the sample that is actually imaged on the camera.

When such targeting errors become substantial compared to the span of the HM image (for example, when the HM image spans 200nm and the targeting error exceeds 50nm), then the HM image no longer properly captures the targeted ice foil and the SPA data acquisition becomes inefficient. Therefore, existing methods for collecting large sets of SPA images can employ a process for calibration of image shift to reduce targeting errors in SPA data acquisition. State-of-the-art image shift calibration processes typically comprise the steps of

(1) at a medium magnification (MM, ~5000x), taking a predefined number of auxiliary or "calibration images" or "foil hole images" which are centered around a pre-defined subset $\{u_i\}$ of the targeted positions of the ice foils or foil holes that are to be recorded at high magnification (here the $u_i$ are two-dimensional vectors denoting the applied image shift),

(2) using image processing algorithms to precisely locate the centers of the holes in the calibration images acquired in (1), and from that, derive the set $\{u'_i\}$ of the actual positions on the specimen that were imaged on the camera (here $u'_i$ are two-dimensional vectors denoting the actually observed image shift); the targeting errors $\Delta_i$ are given by the differences between the targeted positions and the actually imaged positions, $\Delta_i = u'_i - u_i$;

(3) fitting a <u>linear</u> model $u'^{fit}_i = M \cdot u_i + S$ to the dataset $\{u_i, u'_i\}$, where the 2x2 matrix $M$ accounts for possible scaling, rotation, and shear, and the vector $S$ accounts for possible shifting - alternatively and equivalently, the linear model could also be fitted to the data set $\{u_i, \Delta_i\}$ using the model $\Delta^{fit}_i = (M - 1) \cdot u_i + S$, where $1$ denotes the 2x2 identity matrix;

(4) applying the model fitted in (3) to acquire HM images at calibrated positions

$$\boldsymbol{u}^{cal} = \boldsymbol{M^{-1}}(\boldsymbol{u} - \boldsymbol{S}).$$

However, there are several pitfalls in the above-described state-of-the-art calibration process, such as:

(1) The targeting error has <u>non-linear</u> components that are not modeled.

(2) The predefined subset of target areas and the acquisition order cannot be adjusted during the calibration. This can lead to measurement errors while locating the centers of foil holes due to the periodicity of the foil hole pattern.

(3) No knowledge of the sample height variability is used.

(4) Since the foil hole center finding algorithm only recognizes certain predefined geometrical shapes, it cannot work with a sample that contains irregular holes.

(5) Directional bias may be introduced in the fit if the calibration targets are not appropriately selected.

For this reason, current implementations of the SPA acquisition protocol limit the image shifts to, typically, less than about 12 micrometers in order to prevent excessive targeting errors that would otherwise compromise the effectiveness of the SPA acquisition process. Therefore, current implementations of the SPA acquisition combine image shifts with mechanical moves of the sample, where the latter are used to make shifts that are larger than, typically, 12 micrometers.

The following documents relate to automated electron microscopy:

Liu Jinxin ET AL: "Fully Mechanically Controlled Automated Electron Microscopic Tomography" describes "a fully mechanical control method for automating ET data acquisition without using beam tilt/shift processes."

KEVIN M ROCCAPRIORE ET AL: "Identification and Correction of Temporal and Spatial Distortions in Scanning Transmission Electron Microscopy" describes a "Gaussian process (GP)-based regression method for quantification of the distortion function."

Van Horssen E.P. ET AL: "Image-based feedback for drift compensation in an electron microscope" describes "a model-based control system that leads to the stabilization of the region of interest of the object in the center of the field of view despite the presence of drift, which can be achieved by controlling the movement of the object itself using an actuated positioning system (stage)."

It is the intention of the present invention to reduce the targeting errors, so as to enable longer-range image shifts, and by that, to reduce the number of required stage moves, and by that, to reduce the time needed for a complete run of SPA acquisition.

## Summary

The state-of-the-art image shift calibration process in SPA data acquisition described above may be subject to targeting errors that cannot be explained by a linear model alone. Furthermore, the process does not allow for on-the-fly adjustment of the predefined locations without re-executing the entire calibration procedure. It also does not take the sample height into account. This invention therefore seeks to provide an improved calibration process. The scope of the present invention is defined in the claims.

The proposed method improves upon existing methods by accounting for non-flatness and tilt of the sample (which leads to sample height variation) and higher-order discrepancies between LM and HM modes. It also allows on-the-fly adjustment of predefined auxiliary images (details described below). These factors may be accounted for in addition to linear shift, scaling, rotation, and shear discrepancies between LM and HM modes (as being applied in combination with existing techniques for correcting aberrations).

The following method for improved image shift calibration is proposed ("calibration method 1"):

(1) Acquiring a grid square image at low magnification;
(2) Identifying a set of target locations for data acquisition in the grid square image;
(3) Selecting a subset $\{u_i\}$ of target locations from the set of target locations for image shift calibration;
(4) For each target location $u_i$ in this subset of target locations:

    a. Steering the electron beam to the target location using image shift;
    b. Acquiring a calibration image at a medium magnification;
    c. Using image processing techniques to find the shift $\Delta_i$ between the target location in the grid square image and the actually imaged location in the calibration image;

(5) Fitting a non-linear model $\Delta(u)$ to data pairs $(u_i, \Delta_i)$
(6) Applying the model to the complete set of target locations, to produce corrected target locations $u^{cal} = (\Delta + 1)^{-1}(u)$ that account for the predicted targeting error.
(7) Proceeding with data acquisition at high magnification using these corrected target locations.

The model in (5) may be based on smooth functions, e.g., Zernike polynomials, to capture smoothly varying global targeting error behavior. Such a polynomial-based model may have the general form

$$\mathbf{\Delta(u)} = \sum_{k=0}^{K}\sum_{m=0}^{k} c_{mk}\, u_x^{k-m} u_y^{m}$$, where $K$ is the degree of the polynomial, $u = (u_x, u_y)$ is a target location, and $c_{mk} = (c_{mk,x}, c_{mk,y})$ are coefficient vectors.

The model may additionally account for local variations of targeting error, e.g., by including Gaussian process regression ("kriging") or parametric approaches like spline interpolation.

Performing the inversion (6) may be infeasible if, for example, no closed-form inverse $(\Delta + 1)^{-1}$ exists. In this case, one can directly fit an inverse model $\Delta^{-1}(u')$ to data pairs ( $u_i', -\Delta_i$ ), with actually imaged locations $u_i'$ as defined in (2) above. The thus fitted inverse model can then be used according to $u^{cal} = u + \Delta^{-1}(u)$ to calculate calibrated positions for imaging.

Alternatively, one may use the relation $u' = u + \Delta(u) \approx u + \Delta(u') \Rightarrow u = u' - \Delta(u')$ and compute calibrated locations $u^{cal} = u - \Delta(u)$, i.e., use $1 - \Delta$ as a first-order approximation of the inverse $(1 + \Delta)^{-1}$.

The image processing techniques mentioned in (4)c may be based on feature recognition and matching, e.g., circle detection. Alternatively, pixel-based methods for image registration, e.g., mutual information image registration, may be used to find shifts between images. The latter class of methods have the advantage that they do not assume a particular type of feature to be present in the images, which makes them more general than methods aimed at recognizing specific image features (a drawback of feature-based methods mentioned as item (4) in the list of pitfalls with a state-of-the-art approach in the previous section).

Because foil hole patterns are typically periodic and no other large and/or high-contrast features are usually in the field of view, image registration or other shift measurement techniques are prone to failure if the targeting error is too large. For example, if the targeting error is comparable to the distance between foil holes, image registration or feature matching techniques will typically align features that are offset by one foil hole distance, yielding an incorrect targeting error measurement. To address this issue, a second method is proposed where successive model fits and location corrections limit the remaining targeting error ("calibration method 2"):

(1) Acquiring a grid square image of a sample at low magnification;
(2) Identifying a set of target locations for data acquisition in the grid square image;
(3) Selecting a subset $\{u_i\}$ of target locations from the set of target locations for image shift calibration;
(4) Ordering the subset of target locations such that the targeting error is expected to grow from the beginning of the subset to the end;
(5) Initializing a set of calibrated target locations $\{u_i^{cal}\}$ where the initial value of each calibrated target location equals the original target location, i.e., initially $u_i^{cal} = u_i$ for all positions $i$;
(6) For each target location $u_i$ in the subset of target locations:

   a. Steering the electron beam to the corrected target location $u_i^{cal}$ using image shift;
   b. Acquiring a calibration image at an intermediate magnification;
   c. Using image processing techniques to find the shift $\Delta_i$ between the target location in the grid square image and the actually imaged location in the calibration image;
   d. Fitting a non-linear model to data pairs $(u_i, \Delta_i)$ available so far;
   e. Applying the model in d to the subset of target locations, to update the set $\{u_i^{cal}\}$ of calibrated target locations;

(7) Applying the model to the complete set of target locations, to produce corrected target locations $u^{cal}$ (using one of the methods described earlier) that account for the predicted targeting error;
(8) Proceeding with data acquisition at high magnification using these corrected target locations.

The selection in (3) is done such that the area of foil holes (e.g., the convex hull of all target locations) is covered with selected points such that a model with small modelling error (e.g., less than 30 nm at any foil hole location) can be fit with the fewest selected points possible. Typically, for smooth targeting error fields, this can be achieved by a spatially uniform coverage using 12 locations in a grid square with 50 um side length. Since the targeting error $\Delta_i$ usually grows with increasing distance from the optical axis, one possibility to perform the ordering in (4) is to order from smallest to largest distance from the optical axis.

It should be noted that for both methods 1 and 2, the subset of target positions selected for calibration of the targeting need not coincide with the target locations that are used for data acquisition eventually. The target positions selected for targeting error calibration can be placed arbitrarily within the field of view of the grid square image, so long as:

- these target positions contain features suitable for image registration in the field-of-view at the target position (e.g., the target position should not be in a region that is non-transparent to the electron beam),
- this subset of target positions allows to fit a targeting error model that will be accurate for all data acquisition locations (but might be inaccurate in areas not used for data acquisition), and
- these target positions are reachable by image shift.

A natural choice for this set of target positions for performing the targeting error calibration is the set of (or a subset of) the target locations for data acquisition (except for pathological situations, e.g., all locations lie on a straight line). However, other choices are possible, e.g., a uniformly spaced set of locations with a chosen cardinality within the image shift range. Note that it can be advantageous to intentionally to minimize the overlap between these two sets, in order to minimize the electron dose per location, thus minimizing the radiation damage per location. In addition, choosing the two sets independently can help avoid directional bias in the model fit that may be introduced by a directionally biased set of target locations for imaging (mentioned as item (5) in the list of pitfalls of a current state-of-the-art method in the previous section).

The data acquisition after calibration takes a significant amount of time per grid square, even when image shift is used exclusively. This can be an issue for the calibration if there is sample drift. For example, with 500 foil holes in a grid square and 2 seconds of acquisition time per foil hole, the processing time for a grid square is about 16 minutes. With a linear drift of 2 nanometers per minute, this drift introduces additional targeting error of more than 30 nanometers at the last acquired foil holes, which may be unacceptable for data acquisition. Furthermore, during data acquisition, more information about the sample height becomes available, e.g., via contrast transfer function (CTF) measurement, which allows to explicitly model the targeting error component due to sample height variation.

Therefore, a dynamic procedure for updating the targeting model during acquisition is proposed ("calibration method 3"):

(1) Performing calibration method 1 or 2 to fit a targeting model $\Delta$ and produce the set of corrected target locations $u^{cal}$;

(2) Choosing a recalibration criterion to decide during acquisition whether the targeting model needs to be recalibrated;

(3) For each target location in the set of target locations:

a. Deciding, using the recalibration criterion in (2), whether to recalibrate the targeting model - if no, proceeding with g;

b. Steering the electron beam to one or more of the corrected target locations $u_i^{cal}$ using image shift;

c. Acquiring a calibration image at an intermediate magnification;

d. Using image processing techniques to find the apparent shift $\Delta'_i$ between the target location $u_i$ in the grid square image and the actually imaged location $u'_i$ in the calibration image;

e. Fitting a non-linear model to data pairs $(u_i, \Delta_i) = (u_i, \Delta(u_i) + \Delta'_i)$ available so far;

f. Applying the model in e to the subset of target locations, to update the calibration model and to produce improved corrected target locations $u^{cal}$ that account for the predicted targeting error;

g. Performing data acquisition at high magnification with image shift using the improved corrected target locations.

The recalibration criterion in (2) used to trigger a recalibration may be based on

i. the number of acquisitions since the previous calibration exceeding a certain pre-defined number of acquisitions; or

ii. the time elapsed since the previous calibration exceeding a certain pre-defined time interval; or

iii. the measured targeting errors $\Delta_i$ exceeding a certain pre-defined maximum targeting error $\Delta^{max}$;

or a combination of those. The recalibration criterion may additionally take into account whether optical settings have changed since the last calibration.

The model in e may use the same form as in method 1 or method 2. It may additionally account for sample height variation using an explicit model relating (signed) distance from the ideal sample plane to targeting error contribution. This relation is further detailed below.

As in methods 1 and 2, the target positions used to calibrate the model in (3)b-f need not be taken from the set of locations intended for data acquisition. For example, if the recalibration is solely intended to correct for drift, the same area may be used for calibration in each iteration of the loop (3). In this case, the model fit in (3)e might be the original model obtained in (1), where all parameters are fixed, except for a shift parameter that is fit to the newly obtained measurement.

To avoid the overhead of switching to an intermediate magnification in (3)c, the shift measurement may be carried out using the high magnification images acquired in (3)g, yielding the following procedure ("calibration method 4"):

(1) Performing calibration method 1 or 2 to fit a targeting model $\Delta$ and produce the set of corrected target locations $u^{cal}$;

(2) Choosing a recalibration criterion to decide during acquisition whether the targeting model needs to be recalibrated;

(3) For each target location in the set of target locations:

a. Deciding, using the recalibration criterion in (2), whether to recalibrate the targeting model - if no, proceeding with c;

b. Fitting a non-linear model to data pairs $(u_i, \Delta_i) = (u_i, \Delta(u_i) + \Delta'_i)$ available so far;

c. Applying the model in b to the subset of target locations, to update the set $\{u_i^{cal}\}$ of corrected target locations that account for predicted targeting error;

d. Performing data acquisition at high magnification with image shift using the corrected target locations;

e. Using image processing techniques to find the shift $\Delta_i'$ between the target location $u_i$ in the grid square image and the imaged location in the image acquired in (3)d.

In general, a method of automated data acquisition for a transmission electron microscope is provided. The method comprises:

obtaining a reference image of a sample at a first magnification;
for each of a first plurality of target locations identified in the reference image:

steering an electron beam of the transmission electron microscope to the target location,
obtaining a calibration image of the sample at a second magnification greater than the first magnification, and
using image processing techniques to identify an apparent shift between an expected position of the target location in the calibration image and an observed position of the target location in the calibration image,

training a non-linear model using the first plurality of target locations and the corresponding apparent shifts;
based on the non-linear model, calculating a calibrated target location for a next target location;
steering the electron beam to the calibrated target location and obtaining an image (of the sample) at a third magnification greater than the first magnification.

One way in which the proposed method differs from known methods is by training a non-linear model to account for apparent shifts of features. Here, the term "non-linear" is to be understood in the sense "not necessarily linear". In other words, non-linear models comprise linear components and non-linear components. Existing methods may account for linear effects (such as those brought about by first-order optical characteristics of the lenses). However, they do not account for higher-order discrepancies.

Calculating a calibrated target location for a next target location may equivalently be thought of as calculating a calibrated beam shift. Calculating a calibrated "target location" may conceptually be thought of as anticipating and correcting for movement of the sample during beam steering (so the beam is steered to a different location). A calibrated "beam shift" may conceptually be thought of as the sample remaining still, but the beam shift operation not being accurate (so the beam steering operation itself requires calibration). Either way, the construction of the model is the same, but the signs of the errors will be inverted. In other words, if the sample appears to move during a shift operation, further beam shift may be used to track the sample. If the targeting model for steering the beam shift appears incorrect (because an incorrect location is imaged), this is detected and a correction is applied to "aim off", to fix the targeting error. These two effects and processes have reversed signs. However, each is mathematically analogous. Therefore, the true source of error may be neglected, and the approach described above may be employed to address both. Sample drift may be misinterpreted as a targeting error and the correction will be the same as tracking the drift.

Obtaining a reference image of a sample at a first magnification may comprise obtaining a montage of higher magnification images. In this way, the reference image has a greater span or field of view (FOV) than a single higher magnification image.

Obtaining an image may comprise obtaining one or more images (e.g., at the third magnification). In other words, multiple images may be acquired per target location.

Some prior art methods constrain the targeting models to predict discrepancies that result from a pre-set selection of physical effects. In other words, they create a constrained parameterized model that accounts for some physical causes of discrepancies and then calibrate the parameters of the model by taking some measurements. These methods may neglect discrepancies having physical causes not considered when developing the model (including, for example, some higher-order optical distortions). In contrast to such prior art methods, examples of the method proposed in this application do not constrain the model in this way. Instead, proposed methods provide a non-linear model with more freedom to account for discrepancies (such as higher-order discrepancies with indeterminate cause), without requiring mathematical components of those discrepancies to be specifically added to the model. In this way, the proposed methods may provide a more reliable model by allowing the data obtained from real images captured and analysed using image processing to define the model. Advantageously, the model may be continually refined as more measurements are obtained from analysis of real images captured.

Obtaining a calibration image at the second magnification or an image at the third magnification may comprise obtaining the image immediately after the beam has been steered. In other words, the beam is steered to the target location and then the image is captured at the target location.

Identifying the apparent shift between the expected position of the target location in the calibration image and the observed position of the target location in the calibration image may comprise identifying one or more features of the sample at or around the target location in the reference image and identifying those same features at locations in the calibration image. When referring to an "expected" position, this may be the position of the target location in the calibration image that would result if the beam steering process worked perfectly. Therefore, after steering the beam to the target location, the expected position of the target location in the calibration image may be at the centre of the calibration image. When steering to a calibrated target location that is different from the target location, the expected position may be offset from the centre of the calibration image by the predicted apparent shift.

Calculating a calibrated target location for a target location may comprise adding the predicted apparent shift at the target location to the target location. This may predict and compensate for the predicted targeting error.

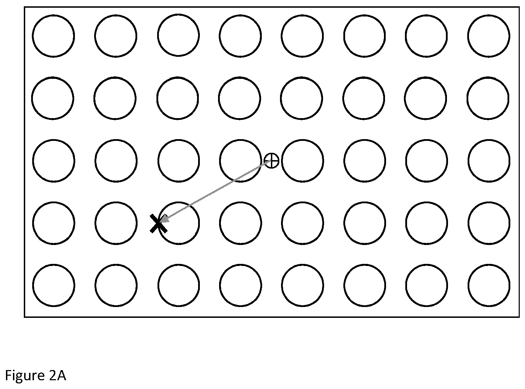

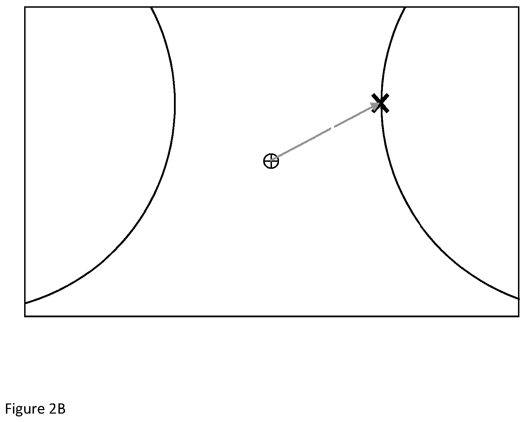

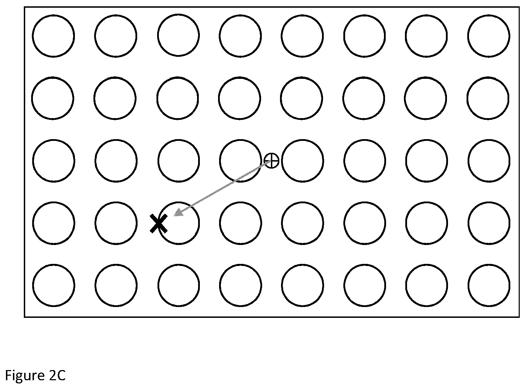

As illustrated in Figures 2A to 2D, adding an offset $d$ to the target location should cause a feature to move by $-d$ in the calibration image. Image 2B is obtained at the target location with no calibration and an offset $d$ of a feature from its expected location is observed in the calibration image (illustrated by the arrow in Figure 2B). The targeting error is $\Delta = -d$, whereas the apparent shift is $S = d$. To compensate for this error (approximately), the calibrated target location (illustrated by the arrow in Figure 2C) is obtained by subtracting $\Delta$ from the target location (or by adding the predicted apparent shift to the target location). Predicted targeting error and measured targeting error follow the same sign convention.

Alternatively, calculating a calibrated target location for a given target location may comprise identifying a calibrated target location at which the predicted apparent shift would result in the target location being in the centre of an image captured at the calibrated target location. In other words, adding the predicted apparent shift at the *calibrated* target location to the target location. This may provide a calibrated target location that more accurately places the target location at the centre of the image.

Computing a calibrated target location according to this method thus amounts to inverting the model that predicts targeting error, that is, producing a model that predicts where to steer the beam ("aiming off") such that, taking predicted targeting error into account, the desired target location is placed at the centre of the thusly acquired image.

The locations and shifts may be expressed in terms of a coordinate system defined by the reference image or may be determined in another coordinate system. When adding and subtracting, the locations and shifts should be in the same coordinate system.

In particular, target locations may be expressed in the coordinate system of the low-magnification (LM) image as displacement from the centre position in the LM image. This representation is mathematically convenient since the origin of a thusly chosen coordinate system typically coincides with the position imaged if no further image shift is applied (beyond what was applied when acquiring the LM image).

The third magnification may be a level that is useful for obtaining images of the biomolecules embedded in the ice. Images obtained at the third magnification for the purpose of sample analysis may be referred to as "data acquisition" images.

The third magnification may be greater than the second magnification. Therefore, data acquisition images at the third magnification (which may also be called "high magnification", HM) may show more detail than the calibration images at the second magnification (which may also be called "medium magnification", MM). This may be advantageous because for data acquisition images, high magnification settings may be required to image the sample in great detail. For calibration, it may be advantageous to have a lower magnification so that the field of view (FOV) is greater. This increases the number of features visible in the image and therefore, the image shift can be determined more accurately or more unambiguously. Moreover, if certain features such as foil hole edges are not visible in the calibration image (e.g., because the apparent shift of the image is greater than the image FOV), then the image may not be useful for calibration. This is less likely to happen if the calibration image is captured at a lower magnification (because the FOV is greater, but the targeting error remains unchanged).

In some examples, the third magnification and the second magnification may be the same. The calibration images may be used as data acquisition images and vice-versa.

The sample may comprise a perforated foil comprising a plurality of holes, wherein the target location is a location in a first hole of the plurality of holes, wherein the next target location is located in a second hole of the plurality of holes. Optionally, the second hole may be directly adjacent to the first hole. In other words, calibration may be performed using a hole adjacent to the next target location. Targeting errors may be predicted more accurately if calibration data are obtained for holes in the vicinity of the next target location.

In a first example, recalibration may be performed for every hole. The model accuracy may therefore be kept high. In another example, recalibration may be performed only every N holes (e.g., every 10 holes). This may preserve model accuracy, while improving efficiency. In another example, calibration may be performed asynchronously in the background using images captured during data acquisition. In another example, recalibration may be triggered when a model prediction error exceeds a threshold level. This may preserve model accuracy at a required level, while further improving processing efficiency. In another example, the method may maintain a map of locations at which the model is valid. Recalibration may be performed based on a determination that a next target location (or a later target location) in the acquisition order is outside the map of valid locations.

There may be multiple target locations per foil hole. Target locations may be selected at the centre of a foil hole to image the biomolecules suspended in the ice and reduce the proportion of the FOV that is outside the foil hole.

In some cases, the sample may be periodic in nature (e.g., where the sample comprises a grid of holes). In such cases, it may not be possible to correct apparent shifts greater than half the distance between the foil holes. This is because the image processing techniques may mistake features of the neighbouring hole for the hole intended to be imaged. Targeting errors tend to increase as the distance from the optical axis to which the beam is steered increases. Therefore, to ensure the model works at larger values of image shift, it is advantageous to calibrate the model using holes close to the optical axis, then use the calibrated model to image holes further away and recalibrate the model using those holes. Then image holes even further away and so on. In this way, the model can be refined iteratively to accurately target areas with large values of beam image shift.

Steering the electron beam to a target location may comprise inputting the target location into a beam steering process (which is configured to adjust the electron beam by amounts determined by a linear beam steering model).

The non-linear model may be configured to predict the apparent shift when the given target location is input into the beam steering process.

The non-linear model may be configured to estimate an apparent shift based on a target location (in other words, the apparent shift of an image captured when steering the electron beam to the target location using the linear steering model). The non-linear model may be used to determine a calibrated target location based on the target location, in order to account for the estimated apparent shift (which is the negative of the "predicted targeting error"). The electron beam can then be steered to the calibrated target location (using the linear steering model), rather than the target location. In this way, the apparent shift is accounted for, and the target location appears closer to the centre of the image captured after steering the beam to the calibrated target location than it would in an image captured after steering the beam to the target location.

The method may further comprise ordering the first plurality of target locations such that a magnitude of the corresponding apparent shift for each target location is expected to increase from start to end (e.g., by ordering the target locations in order of increasing distance from the optical axis or in a spiral shape spiralling out from the optical axis).

The method may further comprise:

ordering the first plurality of target locations such that a magnitude of each target location (preferably, as a vector from the reference image centre) increases from start to end (e.g., by ordering the target locations in order of increasing distance from the optical axis); and/or
ordering the first plurality of target locations such that an angle of the target location changes smoothly from start to end (e.g., by ordering the target locations so that they form a spiral shape spiralling outwards from the optical axis);
wherein, for each of the first plurality of target locations identified in the reference image, the method further comprises calculating a calibrated target location (for the next target location), based on the non-linear model (updated after processing the previous calibration image),
wherein steering the electron beam to the target location comprises inputting the *calibrated* target location into a beam steering process,
wherein, the method further comprises updating the non-linear model after identifying each apparent shift, based on the calibrated target location and the corresponding apparent shift.

Since an angle of $2\pi$ radians is equivalent to an angle of 0 radians, the skilled person will understand that the angles of the target locations (expressed as vectors with respect to the centre of the reference image) may loop around a full circle. The absolute value of the angle may therefore appear to jump when passing the axis from which angles are measured, when moving through the ordered list. Nevertheless, the angles may be changing smoothly when moving through the ordered list in terms of having a relatively small angle between adjacent locations in the ordered list of target locations.

In some of the example methods above, a calibration image is obtained after steering the electron beam to the calibrated target location, rather than the target location. In this case, the expected position of the target location may be at the centre of the calibration image obtained at the calibrated target location (because the predicted apparent shift has been accounted for by using the calibrated target location). Therefore, the feature at the original target location is expected to be in the image centre. If the feature is not in the centre of the image, a shift measurement between the observed features may be performed to obtain a residual error. The residual error may be added to the predicted error for the target location to obtain the total targeting error. Advantageously, using the calibrated targeting location for imaging makes the measurement process easier, because the image shifts are expected to be smaller.

In another example, the apparent shift may be calculated as the apparent shift between the expected position of the *calibrated* target location (rather than the original target location) and the observed position of the calibrated target location in the calibration image. In this case, the calibrated target location may be expected in the centre of the calibration image (because the "expected" position is based on the steering model and does not account for the predicted apparent shift).

The method may further comprise initializing a set of calibrated target locations using the original target locations, and updating the set of calibrated target locations by replacing the respective target location with the calibrated target location, calculated for the next target location based on the non-linear model.

Training the non-linear model may comprise fitting a non-linear model to data pairs $(\boldsymbol{u}_i, \boldsymbol{u}'_i)$, where for the i-th target location in the first plurality of target locations, $\boldsymbol{u}_i \varepsilon R^2$ is the target location as identified in the reference image, and $\boldsymbol{u}'_i \varepsilon R^2$ is the actual position on the specimen as identified using image processing techniques, and $\varDelta_i = \boldsymbol{u}'_i - \boldsymbol{u}_i$ is the corresponding apparent shift (or "targeting error") as identified using image processing techniques.

The next target location may be one of a second plurality of target locations and the method may comprise, for each of the second plurality of target locations:

calculating a calibrated target location, based on the non-linear model,
steering the electron beam to the calibrated target location, and
obtaining an image of the sample at the third magnification.

The second plurality of target locations may be identified in the reference image or in a second reference image. The second reference image may be an image of the sample or of a second sample.
The method may further comprise:
for each of the second plurality of target locations:

determining whether the non-linear model is still valid, based on one or more predetermined criteria (the determination of whether the model is valid is performed before using the non-linear model to calculate the calibrated target location);
if recalibration is required, obtaining an image of the sample at the second magnification (at the current one of the second plurality of target locations), using image processing techniques to identify an apparent shift between an expected position of the target location in the image and an observed position of the target location in the image, updating the non-linear model based on the apparent shift.

If recalibration is required, the method may further comprise:

calculating a preliminary calibrated target location, based on the non-linear model (the old non-linear model that requires recalibration), and
steering the electron beam to the preliminary calibrated target location.

Updating the non-linear model based on the apparent shift may comprise updating the non-linear model using the preliminary calibrated target location and the corresponding apparent shift.
Obtaining an image of the sample at the third magnification may comprise performing data acquisition at high magnification with image shift using the calibrated target location.
The method may further comprise:
for each of the second plurality of target locations:

determining whether the non-linear model is still valid, based on one or more predetermined criteria (prior to calculating the calibrated target location, based on the non-linear model);
if recalibration is required, using image processing techniques to identify an apparent shift between an expected position and an observed position of the immediately preceding target location from the second plurality of target locations in the corresponding image obtained at the third magnification (obtained during the previous cycle), and updating the non-linear model based on the calibrated target location and the corresponding apparent shift.

In other words, if recalibration is required, the method may further comprise:

using image processing techniques to identify, in the image of the immediately preceding target location from the second plurality of target locations obtained at the third magnification, an apparent shift between an expected position and an observed position of the immediately preceding target location, and
updating the non-linear model based on the calibrated target location for the immediately preceding target location and the corresponding apparent shift.

The previous image obtained at the immediately preceding target location may be the image of the sample obtained at the at the third magnification. Advantageously, a separate calibration image at intermediate magnification may not be required.
For the first of the second plurality of target locations, there is no immediately preceding target location. However, the model has only just been trained and may therefore be assumed to be valid.
The updated model may be subject to model quality checks. For example, the new model may be rejected if the parameters are outside a chosen range of valid parameters. The new model may also be rejected based on quality metrics (such as the quality of fit on the measured targeting errors for a chosen error metric).
The updated model may also take into account all the previous data pairs collected so far.
Updating the non-linear model may comprise fitting a non-linear model to data pairs ($\boldsymbol{u}_j$, $\boldsymbol{u'}_j$), where for the j-th target location in the second plurality of target locations, $\boldsymbol{u}_j \varepsilon R^2$ is the calibrated target location, and $\boldsymbol{u'}_j \varepsilon R^2$ is the actual

position on the specimen as identified using image processing techniques, and $\Delta_j = \boldsymbol{u'}_j - \boldsymbol{u}_j$ is the apparent targeting error.

Calculating a calibrated target location, based on the non-linear model, may comprise applying the updated model (that more accurately predicts the targeting errors) to the target locations, to provide calibrated target locations.

The method may further comprise choosing a recalibration criterion to decide, during data acquisition, whether the targeting model needs to be recalibrated. The recalibration criterion may be used when determining whether the non-linear model is still valid.

Determining whether the non-linear model is still valid may comprise deciding, using the recalibration criterion, whether to recalibrate the targeting model.

The method may further comprise, for each of the second plurality of target locations: using image processing techniques to find the apparent shift of the target location (from the grid square image) between the expected position and the imaged location in the image of the sample obtained at the third magnification.

The non-linear model may comprise a plurality of model components, each component may have one or more separate validity criteria. For example, moving the stage to a new grid square may invalidate certain components of the model but not others. Taking a new reference image may invalidate certain components of the model but not others. Shifting the beam further than previously may invalidate certain parts of the model but not others. Determining whether model is still valid may comprise determining whether each model component is still valid. Updating the non-linear model may comprise updating model components that are determined not to be still valid and retaining model components that are determined to be still valid, without any update. Advantageously, updating the model selectively in this way may be more efficient and may result in a more reliable model.

Determining whether the model is still valid based on one or more predetermined criteria may comprise assessing whether the optical settings have changed compared to the optical settings during acquisition of the images used to fit the current model. The assessment may further be based on prior knowledge on the current grid square as compared to the grid square on which the current model was fit. For example, this prior knowledge may include an estimate of height deviation, level of contamination, cracks, etc. The assessment may further be based on the time since the last calibration, a total drift estimation, or a combination thereof.

In general, the locations used to calibrate the model (the first plurality of target locations) need not overlap with the set of locations intended for data acquisition (the second set of target locations). However, in some circumstances they could be, as explained below.

The first plurality of target locations may be selected such that the target locations and identified apparent shifts are sufficient for training the non-linear model, such that the non-linear model is accurate at the second plurality of target locations.

The method may further comprise:

identifying (receiving/determining) a third plurality of locations of interest in the reference image;
selecting the first plurality of target locations as a subset of the third plurality of target locations.

In other words, a selection of the target locations may be used to calibrate the model.

The second plurality of target locations may be identical to the third plurality of target locations. In other words, a "data acquisition" image at the third magnification may be captured for each target location of interest. Alternatively, if the calibration images at the second magnification are acceptable, data acquisition images at the third magnification may not be needed for target locations at which a calibration image has been obtained. Therefore, the second plurality of target locations may be a subset of the third plurality of target locations.

Each of the first plurality of target locations, the next target location, the second plurality of target locations and/or the third plurality of target locations may be selected such that:

the sample comprises one or more features suitable for image registration in proximity to each target location, such that one or more of the features are visible in an image obtained at the target location, and/or
each target location is located within a threshold distance from an optical axis of the microscope, such that the target location is reachable by image shift.

The method may further comprise initialising the model (e.g., with an "identity" model, which predicts no apparent shift at any location). Training the model may comprise updating the model using the data pairs.

Steering an electron beam of the transmission electron microscope to the target location may comprise using a linear steering model to move the electron beam, based on a position of the target location in the reference image.

The "target location" is a location on the sample (a feature of interest) and is also a point in the reference image (where the feature of interest appears in the reference image). Steering the beam to the target location identified in the reference image may comprise

estimating a physical position of the target location of the sample in the microscope, based on the position of the target location in the reference image and

steering the electron beam to the physical position using a linear steering model.

Calculating a calibrated target location may comprise determining a location that the beam should be steered to using the linear steering model, such that, when the targeting error is added to the calibrated target location, the desired target location appears close to the centre of the image.

Third magnification may be the same as the second magnification or may be greater than the second magnification.

Rather than using the same linear steering model (which we know results in targeting errors) and steering the image to a corrected location to account for the anticipated error, the steering model could be updated to account for the non-linear behaviour and the beam could be steered to the target locations using the corrected model. In other words, the non-linear targeting model could be incorporated into the steering model. Whilst the non-linear model is recalibrated as described above, the linear steering model may remain the same. This may be because the linear steering model is based on physical properties of the microscope that do not change.

The method may further comprise obtaining a second reference image of the sample (or a different sample) at the first magnification. The second reference image could show a different location of the same sample, such as a different grid square. Alternatively, the second reference image could show a different sample altogether.

The method may further comprise identifying a second plurality of target locations in the second reference image.

The non-linear model may be configured to estimate an apparent shift of a feature of the sample (a feature that is located at the target location identified in the reference image) in an image obtained by steering the electron beam to the target location (using the linear steering model. In other words, the non-linear model is configured to predict an apparent shift for a given target location, the apparent shift is the difference between the position that would be expected if the linear steering model was perfect - the centre of the image - and the position in the image in which we actually expect to observer the feature, given that the steering model is imperfect).

The non-linear model may account for deviations of the real sample from the ideal flat sample plane. In some examples, the non-linear model assumes that the real sample is smooth.

Estimating the apparent shift using the non-linear model may comprise estimating a difference between a physical location of the feature and a projection of the feature onto an imaging plane of the microscope. In other words, the model may take the z-offset of the sample at the target location into account. The z-offset at a target location may be estimated based on one or more estimated or determined z-offsets for other features of the sample (at other nearby locations), assuming that the sample is smooth (assuming the sample height varies smoothly between the features of the sample). The origin of the z-axis may coincide with the optical plane (at or near the sample) which the microscope images on the image detector (for conciseness often referred to as the "image plane"), and the direction of the z-axis may coincide with the principal direction of beam propagation ("optical axis").

When estimating the z-offset, the stage height and tilt may be taken into account. The z-offset may therefore be split into two components:

a difference between an idealised flat sample plane and the image plane, as may be caused by a tilt of the sample and optionally on a shift-of-height of the stage above the image plane; and
an offset of the feature of the sample from the idealised flat sample plane.

Such z-offset may be estimated in a number of ways. One way in which the z-offset may be measured is based on determining the defocus at the imaged data acquisition location. This measurement is typically performed by analysing the power spectrum of an acquired image and fitting a model of the contrast transfer function (CTF) of the imaging system, in which defocus is a key parameter. Since defocus is directly proportional to the z-offset of the imaged location from the imaged plane, measured defocus can be used to determine this z-offset.

One other way in which the z-offset may be estimated is by determining an expected position of the feature using the measurements already taken and a model that accounts for optical aberrations and/or stage tilt, assuming that any residual difference is due to height discrepancies between the position of feature and the ideal flat sample plane and estimating the z-offset using the residual apparent shift.

Steering the electron beam may comprise adjusting a tilt and/or shift of the electron beam. Adjusting the tilt and/or shift of the electron beam may comprise:

adjusting the incident electron beam (moving the illumination beam), and/or
adjusting the transmitted electron beam (moving the camera FOV).

The method may further comprise using a transformation operation to map a location (and/or orientation) of one or more features identified in the reference image to a corresponding location (and/or orientation) in the calibration image. The transformation operation may comprise one or more rotation, translation and/or scaling operations.

The transformation operation may take the estimated z-offset into account.

Using image processing techniques to identify an apparent shift between the expected position of the target location in the calibration image and the observed position of the target location in the calibration image may comprise:

determining the expected position of the feature in the calibration image, using a (linear) steering model;
identifying the feature in the calibration image at an observed position (e.g. using feature detection and feature matching processes);
determining the apparent shift as the difference between the expected position and the observed position.

Where the sample comprises a perforated foil comprising a plurality of holes, the target location may be a location within one of the holes. Identifying a feature/target location in the first image may comprise identifying an edge of the hole in the first image. Identifying the feature in the calibration image may comprise identifying the edge of the same hole in the calibration image.

The method may further comprise:

obtaining a defocus measurement for one or more calibration images;
updating the non-linear model based on the defocus measurement.

The method may further comprise:
using the defocus measurement to infer a z-offset of the feature (a difference between the physical location of the feature and the projection of the feature onto the imaging plane of the microscope).

Training/updating the non-linear model may comprise using the target locations, the corresponding apparent shifts, and the corresponding defocus measurements.

The method may comprise iteratively obtaining images at the second magnification and refining the non-linear model by performing one or more cycles. Each cycle may comprise the steps of:

identifying a target location in the reference image;
steering the electron beam to the target location;
obtaining a calibration image at the second magnification at the target location; and
identifying a reference feature at an observed position in the calibration image, determining an apparent shift as the difference between the observed position and an expected position (obtained using the linear steering model), and updating the non-linear model based on the apparent shift; and/or
obtaining a defocus measurement for the calibration image, using the defocus measurement to infer a z-offset for the feature, and updating the non-linear model based on the z-offset.

Iterative cycles to update the model may be repeated until a first number of images for which a residual targeting error is used to update the targeting model reaches a first threshold and/or a second number of images for which a defocus measurement is used to update the targeting model reaches a second threshold.

In another example, a method of automated data acquisition for a transmission electron microscope is provided, the method comprises:

obtaining a reference image of a sample at a first magnification;
for each of a first plurality of target locations identified in the reference image:

shifting a stage of the transmission electron microscope to the target location (preferably, to align the target location with the optical axis of the microscope),
obtaining a calibration image of the sample at a second magnification greater than the first magnification, and
using image processing techniques to identify an apparent shift between an expected position of the target location in the calibration image and an observed position of the target location in the calibration image,

training a non-linear model using the first plurality of target locations and the corresponding apparent shifts;
based on the non-linear model, calculating a calibrated target location for a next target location;
shifting the stage to the calibrated target location and obtaining an image at a third magnification greater than the first magnification.

In this way, the proposed methods may also be used to calibrate and correct targeting errors in a stage shifting process. Optional features mentioned above may be equally applied to this method.

A transmission electron microscope apparatus configured to perform one or more of the methods described above is also provided. The apparatus may comprise a transmission electron microscope, a processor for executing the instructions and a memory for storing the instructions.

Computer software comprising instructions that, when executed on a processor of a computer, cause the computer to perform one or more of the methods described above is also provided. The software may be executed on a generic computer system communicatively coupled to an electron microscope. Alternatively, the software may be executed on dedicated hardware coupled to the microscope.

**Brief description of the drawings**

Specific non-limiting examples of the present invention will now be described with reference to a number of non-limiting examples.

Figure 1A illustrates a schematic depiction of a charged-particle microscope.

Figure 1B illustrates real SPA images that suffer from targeting inaccuracy.

Figures 2A to 2D illustrate schematic images acquired during one general example implementation. Figure 2A illustrates a reference image showing a target location in the reference image. Figure 2B illustrates a calibration image obtained by steering the electron beam to the target location and the apparent shift of the target location caused by targeting errors. Figure 2C illustrates a calibrated target location in the reference image. Figure 2D illustrates a calibration image obtained by steering the electron beam to the calibrated target location.

Figure 3A illustrates the calibration methods 1 and 2.

Figure 3B illustrates calibration method 3.

Figure 3C illustrates calibration method 4.

Figure 4 illustrates geometric calculation of targeting inaccuracies introduced by sample height change.

Figure 5 illustrates a flow diagram for a specific example implementation of the proposed method.

Figure 6 illustrates targeting errors on a life sciences sample.

Figure 7 illustrates targeting errors on a gold grid sample tilted by 30°.

**Detailed description**

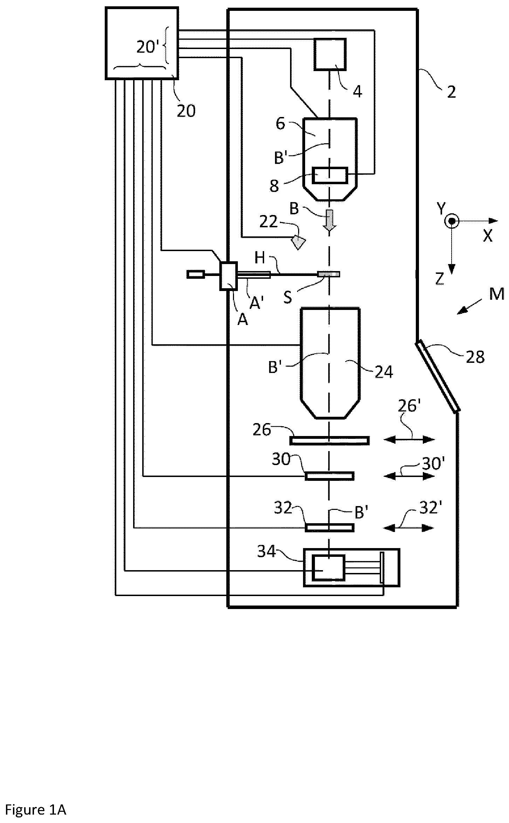

Figure 1A (which is not illustrated to scale) is a highly schematic depiction of an example of a charged-particle microscope M in which the present invention can be implemented. In one example, the charged-particle microscope M may be a transmission-type microscope, such as a transmission electron microscope (TEM). As illustrated in Figure 1A, within a vacuum enclosure 2, an electron source 4 produces a beam B of electrons that propagates along an electron-optical axis B' and traverses an electron-optical illuminator 6, serving to direct/focus the electrons onto a chosen part of a specimen S, which may be (locally) thinned/planarized. Also depicted is a deflector 8, which (*inter alia*) can be used to effect scanning motion of the beam B.

The specimen S is held on a specimen holder H that can be positioned in multiple degrees of freedom by a positioning device / stage A, which moves a cradle A' into which holder H is (removably) affixed. For example, the specimen holder H may comprise a finger that can be moved (*inter alia*) in the XY plane. The Cartesian coordinate system is also depicted in Figure 1A. Typically, motion parallel to the Z axis and tilt about the X/Y axes will also be possible. Such movement allows different parts of the specimen S to be illuminated / imaged / inspected by the electron beam B traveling along axis B' (in the Z direction) and/or allows scanning motion to be performed, as an alternative to beam scanning. If desired, an optional cooling device (not depicted) can be brought into intimate thermal contact with the specimen holder H, so as to maintain it (and the specimen S thereupon) at cryogenic temperatures, for example.

The electron beam B will interact with the specimen S in such a manner as to cause various types of "stimulated" radiation to emanate from the specimen S, including (for example) secondary electrons, backscattered electrons, X-rays and optical radiation (cathodoluminescence). If desired, one or more of these radiation types can be detected with the aid of analysis device 22, which might be a combined scintillator/photomultiplier or EDX (Energy-Dispersive X-Ray Spectroscopy) module, for instance. In such a case, an image could be constructed using basically the same principle as in a SEM. However, alternatively or supplementally, one can study electrons that traverse (pass through) the specimen S, exit/emanate from it and continue to propagate (substantially, though generally with some deflection/scattering) along axis B'. Such a transmitted electron flux enters an imaging system (projection lens) 24, which will generally comprise a variety of electrostatic / magnetic lenses, deflectors, correctors (such as stigmators), and the like. In normal (non-scanning) TEM mode, this imaging system 24 can focus the transmitted electron flux onto a fluorescent screen 26, which, if desired, can be retracted/withdrawn (as schematically indicated by arrows 26') so as to get it out of the way of axis B'. An image (or diffractogram) of (part of) the specimen S will be formed by imaging system 24 on screen 26, and this may be viewed through viewing port 28 located in a suitable part of a wall of enclosure 2. The retraction mechanism for screen 26 may, for example, be mechanical and/or electrical in nature, and is not depicted here.

As an alternative to viewing an image on screen 26, one can instead make use of the fact that the depth of focus of the electron flux leaving imaging system 24 is generally quite large (for example of the order of 1 meter). Consequently, various other types of analysis apparatus can be used downstream of screen 26, as described in more detail below.

One other type of analysis apparatus that can be used downstream of screen 26 is TEM camera 30. At camera 30, the electron flux can form a static image (or diffractogram) that can be processed by controller/processor 20 and displayed on a display device (not depicted), such as a flat panel display, for example. When not required, camera 30 can be retracted/withdrawn (as schematically indicated by arrows 30') so as to get it out of the way of axis B'.

Another type of analysis apparatus that can be used downstream of screen 26 is STEM camera 32. An output from camera 32 can be recorded as a function of (X, Y) scanning position of the beam B on the specimen S, and an image can be constructed that is a "map" of output from camera 32 as a function of (X,Y). Camera 32 can comprise a single pixel with a diameter of 20 mm, for example, as opposed to the matrix of pixels characteristically present in camera 30. Moreover, camera 32 will generally have a much higher acquisition rate (for example, $10^6$ points per second) than camera 30 (for example, $10^2$ images per second). Once again, when not required, camera 32 can be retracted/withdrawn (as schematically indicated by arrows 32') so as to get it out of the way of axis B' (although such retraction would not be a necessity in the case of a donut-shaped annular dark field camera 32, for example; in such a camera, a central hole would allow flux passage when the camera was not in use).

As an alternative to imaging using cameras 30 or 32, one can also invoke spectroscopic apparatus 34, which could be an EELS module, for example.

It should be noted that the order/location of items 30, 32 and 34 is not strict, and many possible variations are conceivable. For example, spectroscopic apparatus 34 can also be integrated into the imaging system 24.

Note that the controller (computer processor) 20 is connected to various illustrated components *via* control lines (buses) 20'. This controller 20 can provide a variety of functions, such as synchronizing actions, providing setpoints, processing signals, performing calculations, and displaying messages/information on a display device (not depicted). Needless to say, the (schematically depicted) controller 20 may be (partially) inside or outside the enclosure 2, and may have a unitary or composite structure, as desired.

The skilled artisan will understand that the interior of the enclosure 2 does not have to be kept at a strict vacuum. For example, in a so-called "Environmental TEM/STEM", a background atmosphere of a given gas is deliberately introduced / maintained within the enclosure 2. The skilled artisan will also understand that, in practice, it may be advantageous to confine the volume of enclosure 2 so that, where possible, it essentially hugs the axis B', taking the form of a small tube (for example of the order of 1 cm in diameter) through which the employed electron beam passes, but widening out to accommodate structures such as the source 4, specimen holder H, screen 26, camera 30, camera 32, spectroscopic apparatus 34, and the like.

Different parts of the sample may be brought into the field of view of the camera 30 either by mechanically shifting the specific parts of the sample to the optical axis, or by shifting the electron beam to towards these specific parts, using the electron beam deflectors of the electron microscope. However, such deflections can induce aberrations and, by that, loss of resolution if these induced aberrations are not properly compensated. This is explained in the following paragraphs.

The resolution and field of view obtainable in electron beam instruments such as scanning electron microscopes, electron beam microprobes and electron beam lithographic machines is limited by aberrations of the optical system. These aberrations can be classified as parasitic and intrinsic. Parasitic aberrations are caused by imperfections of the lens, such as imperfect roundness or inhomogeneities in the magnetic properties of the material generating the magnetic field of the lens. The most well-known parasitic aberration of a lens is (two-fold) astigmatism. Intrinsic aberrations are intrinsic to the lens, and, therefore, they cannot be avoided by careful machining. Intrinsic aberrations are conventionally classified as purely geometric (of which the most well-known aberration is spherical aberration) or energy-dependent (of which the most well-known aberration is the (first order) chromatic aberration). The intrinsic geometric aberrations of third order of a lens are of eight types: isotropic and anisotropic distortion, curvature of field, isotropic and anisotropic off-axial astigmatism, isotropic and anisotropic off-axial coma, and spherical aberration. The words "off-axial" are used to distinguish the off-axial astigmatism and off-axial coma (which are intrinsic aberrations, and which are third order) from the on-axial astigmatism and on-axial coma (which are parasitic aberrations and first and second order, respectively). It should be noted that the words "off-axial" and "on-axial" are often dropped when it is clear from the context which form of astigmatism or coma is meant.

For an image point on the optical axis of the system, only spherical aberration occurs. As the electron beam is focused onto image points farther off axis, the remaining seven aberrations become significant in determining the attainable focused spot size and the degree of distortion present in the image.

Several of these optical aberrations can be corrected with commonly known techniques. The only aberrations which limit the field of view for which some sort of simultaneous correction has not been provided are isotropic and anisotropic coma. As is commonly known, proper placement of the beam defining aperture enables isotropic coma to be cancelled, even in non-scanning electron beam instruments such as the conventional electron microscope. There has been, however, no means of completely correcting the anisotropic coma aberration. Further, the simultaneous correction of anisotropic and isotropic coma while minimizing curvature of field is an issue.

In an illustrative example, the best resolution that a 300 kV STEM microscope (without inbuilt spherical aberration corrector) can give is about 0.10 nm. Typically, this is obtained by scanning the specimen in pixels of about 0.04 × 0.04 $nm^2$. Modern STEM controls can collect images as large as 8000 × 8000 pixels. This corresponds to a field-of-view of 320 × 320 $nm^2$ and a maximum off-axial distance of u=320 nm/√2=226 nm. The blur due to off-axial coma can be calculated as

$$du = \bar{K}\,\bar{u}vv + 2Kuv\bar{v}$$

where K denotes the coefficient of off-axial coma and v denotes the half-convergence angle of the STEM beam at the sample. Here distance and angle and coma are complex numbers u=x+iy and v=$\alpha_x$+i$\alpha_y$ and their complex conjugates are denoted by an added top bar. Since K is typically about 1 (dimensionless) and v is typically 0.012 rad, the off-axial blur in the corners of the image amounts to about 0.098 nm in this example, which degrades the resolution.

In order to understand the nature of the off-axial aberrations, it can be helpful to simplify the objective lens as to be an infinitely thin lens. Ideally, the refractive strength of the lens increases linearly with the distance of the beam to the center of the lens; the associated constant of proportionality equals the inverse focal distance of the objective lens. However, in practice, higher order aberrations cause that the refractive strength deviates from the linear dependence. However, for the infinitely thin lens, any beam that is directed through the center of the lens will not suffer from these higher order aberrations since the refractive power of the lens is zero at its center. Thus, it is possible to scan the sample indefinitely far off-axis without inflicting higher order aberrations to the beam, provided the scanning beam is tilted (or directed) such that it travels through the center of the objective lens. This scheme is known to the skilled person as 'putting the pivot-point in the coma-free plane'. Similarly, for a real, not infinitely thin lens, there is exist a plane, usually fairly close to the center of the lens with the property that no isotropic off-axial coma is introduced when the scanning beam is directed such that it crosses the optical-axis in this plane.

By using a complex pivot point, i.e. adding a shift-dependent tilt correction to the shift, not only the isotropic but also the anisotropic coma can be avoided or corrected.

In conventional SPA, the maximum image shift is set by the aberrations that are introduced by the intrinsic third-order aberrations of the objective lens. The third order aberrations are the relevant quantities, since first order aberrations correspond to (on-axial) astigmatism that can be corrected by a stigmator or a stigmating lens, and 2nd order aberrations vanish, since the system is rotationally symmetric. The following equations quantitatively illustrate this. Denote position and angle at the specimen by the complex numbers u=x+iy and v=$a_x$+i$a_y$ and denote their complex conjugates by an added top bar. The general expression for the shift induced by all third-order aberrations is:

$$du = C_s vv\bar{v} + \bar{K}\,\bar{u}vv + 2Kuv\bar{v} + Fu\bar{u}v + \Lambda uu\bar{v} + Duu\bar{u}$$

where $C_s$=spherical aberration, K=off-axial coma, F=field curvature, Λ=off-axial astigmatism (complex number), D=distortion.

Let us introduce a shift u-u+s and a tilt v-v+t at the specimen. This induces additional aberrations

$$vvB + 2v\bar{v}\bar{B} + df\,v + A\bar{v} + \text{higher order terms,}$$

with effective coma $B = C_s\bar{t} + \bar{K}\,\bar{s}$,
effective defocus $df = C_s 2t\bar{t} + 2\bar{K}\,\bar{s}t + 2Ks\,\bar{t} + F\,s\bar{s}$,
and effective astigmatism $A = C_s tt + \bar{K}st + 2Kst + \Lambda ss$.

In conventional single particle analysis, no tilt is applied, only a shift s. In this case, the effective coma is limiting the maximum image shift.

In this case, when coma B reaches about 2 $\mu$m, it results in a resolution loss of about 1 Å, and this is the maximum resolution loss that is practically acceptable. Applicant's Krios™ transmission electron microscope comprises K=0.15+1.42i, so the maximum allowed image shift is about $S = B/\overline{K} = 2\mu$m/(0.15-1.42$i$) ~1.5$\mu$m. The effective coma can be eliminated by simultaneously applying an image shift s and a beam tilt t with a ratio t=-Ks/C$_s$. This skew illumination is known from U.S. Pat. No. 4,101,813.

Techniques described above for correcting aberrations that arise during image shift processes may be referred to as "Aberration-Free Image Shift" or "AFIS" techniques and are described in US 2021/0272767.

*Aberration Free Image Shift (AFIS) and the influence of sample height:*

When the electron beam passes through the lower objective lens at an off-axial position, the resulting image experiences undesirable phase aberrations, such as coma, which can be detrimental to the final SPA image quality. This off-axial coma can be cancelled by tilting the beam and have it pass through a fixed point in the lower objective lens such that resulting coma is minimal (often called "rotation center" or "coma-free center"). Pivoting the beam around the coma-free point results in a shift that is different for each plane perpendicular to the optical axis above the coma-free center. Thus, to achieve a certain beam shift at the sample, the height of the sample above the coma-free center (the distance between two planes perpendicular to the optical axis, one containing the sample point of interest (target area), the other containing the coma-free center) must be known. For reasons of simplicity, it is common practice to assume that the sample is flat and oriented perpendicular to the optical axis, and that the sample is located at the optical plane that the microscope images at the detector, thus its height above the coma-free center is fixed and known. This sample plane is referred to as the "image plane" or "target plane". The true local height of the sample above the coma-free center is then the sum of the height of the target plane above the coma-free center and the height of the sample point of interest above the target plane (which can be positive or negative, depending on the direction of height deviation from the target plane). We refer to this local deviation of the height of the sample above the target plane as "sample height" or "sample z offset".

In current microscope systems, the translation between desired beam shifts and tilts at a selected target plane and required lens currents is established by a calibration procedure that needs to be carried out by experts. Since this translation is stable across time for each acceleration voltage and requires expert knowledge for re-calibration, it is rarely adjusted even when it is known that the height of the sample (e.g., as derived from the sample stage z coordinate) deviates from the target plane. In particular, it is not common to dynamically adjust the target plane due to local sample height variation (by adjusting the strength of the lenses in the imaging system), even when it is predictable, e.g., when the specimen stage is tilted by a known angle.

Image shift techniques allow collection of image data from off-axis foil holes of the specimen S, without moving the stage A to bring those foil holes closer to the optical axis B'.

In one example, the specimen contains a grid with many circular foil holes each containing an amorphous layer of ice with near identical copies of the molecule to be imaged. Each ice foil hole is about 2 $\mu$m diameter, with average distance around 5 $\mu$m. The stage moves to the center of the hole, and 2 to 6 different image shifts are used to acquire 2 to 6 images, each image covering an area of ca. $0.5{\times}0.5$ $\mu$m$^2$. Then the stage moves to the next hole and the procedure is repeated. This process may be repeated thousands of times, thus generating many thousands of images. From these images the particles are picked, classified, aligned, and averaged to come to a certain resolution in the reconstructed particle. An acquisition session can typically take several days.

The relaxation time of a stage shift may be up to approximately 1 minute, and this waiting time may be a dominating contribution to the total time of a SPA session. This total time could be significantly reduced if instead of stage shifts, image shifts could be used.

Targeting software may be configured to automatically capture images of desired locations by adjusting the deflectors. Existing techniques also aim to predict targeting errors in order to facilitate improved beam control. This may involve a calibration process comparing apparent positions of foil holes observed using low magnification (LM) with the apparent positions of those same foil holes when observed using high magnification (HM). Discrepancies between the apparent positions are fitted with a model and the model is then used to determine linear rotation and scaling discrepancies between LM and HM mode. These discrepancies can then be accounted for when performing targeting to image particular regions at higher magnification during automated operation of the microscope.

There can be a relatively large mismatch between images collected using LM and HM modes (for example in scale, rotation, distortion). One reason for this is that a first imaging (or "intermediate") lens in the projection system 24 of the microscope M is switched on in HM mode and switched off in LM mode.

One example of a single particle analysis (SPA) technique is cryogenic electron microscopy (cryoEM), in which the specimen S comprises sample particles cooled to cryogenic temperatures and suspended in vitreous water. The aqueous sample solution is applied to a foil mesh grid and frozen. The foil mesh grid comprises a number of foil holes, in which the frozen solution is suspended. The foil holes in the mesh grid are then analysed by the microscope M.

Analysis of the foil holes may be performed automatically, to improve the speed at which data is collected. One important bottleneck that limits throughput of automated data collection is the time spent in stage movement of stage A. Each stage move must be followed by a settlement period to reduce drift. In addition, extra tracking steps may be required to compensate for the inaccuracy in stage move. Image shift techniques described above have been designed to reduce the number of stage movements required and thereby increase throughput during automated data collection.

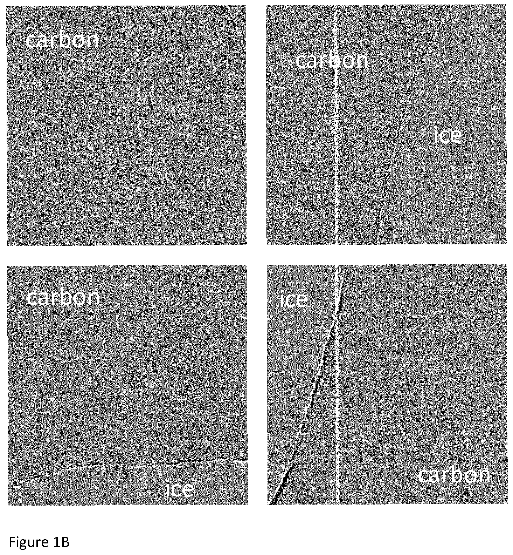

However, the experimental targeting accuracy of image shift in SPA is sometimes found to be worse than 100 nm when the shift distance on the sample plane is larger than 10$\mu$m. Typical bad image examples are shown in Figure 1B, where more than 50% of the field of view (FOV) are unusable (because they image the foil itself, rather than the ice suspended in the foil hole of the specimen S).

Figure 1B illustrates real SPA images that suffer from targeting inaccuracy. The FOV for these images is approximately 300 nm.

To make sure that the beam still touches a part of the conductive supporting film (to help reduce charging effects on the sample), without this illuminated part of the film appearing inside the camera FOV (or at least without the film dominating a majority of the FOV), the targeting accuracy needs to be better than 50 nm. Therefore, the current targeting accuracy limits the effective number of reachable foil holes from a single imaging centre (in other words, the targeting accuracy limits the number of holes that can be imaged, without moving the stage A).

It is the intention of the present invention to improve the targeting accuracy to a value better than 50 nm at shift distances as large as 25 $\mu$m (which is the range limit of current image deflectors). With such an improvement, image shift techniques can cover more area and thereby reduce the number of stage movement per square acquisition. It will also significantly improve the throughput in tilted SPA acquisition (at least 2x), which is proven to be very important for proteins with orientation preference induced by air-water interfaces, like the COVID-19 spike protein.

Significant types of error sources for targeting include:

> 1. non-flatness of the sample;
> 2. defocus in LM mode, causing linear rotation and scaling with respect to HM mode, implying a mismatch between the LM and HM maps; and
> 3. other error sources, such as higher-order distortions and mechanical imperfections of deflectors.

Existing techniques only address error source 2: defocus causing linear rotation and scaling between LM and HM mode. At the start of the collection of a series of images, known techniques collect a few images and fit a linear (scaling and rotation) correction to the observed targeting errors. In this way, possible effects of non-flatness of the sample on the targeting error are neglected, along with possible higher-order distortions.

To address error source 1, the proposed methods in this example take into account that variations of sample height, in combination with the beam tilt chosen for acquisition (since beam tilt is inherent to the illumination scheme), can produce a shift of illumination. This shift may account for a significant portion of the inaccuracy presently affecting known image shift techniques.

To address error sources 2 and 3, on top of compensating for error source 1, in a specific example the proposed method fits a smooth two-dimensional function on-the-fly to the remaining errors to allow accurate error prediction for nearby acquisition areas and thereby further improve targeting. A physical root cause of higher order error contributions may be unknown. However, attributing a physical root cause to the error contributions may not be necessary. The invention may work well by modelling these errors as higher-order terms.

One general example implementation is illustrated with reference to Figures 2A to 2D and may be summarized as:

> 1) Acquire an overview image $I(\boldsymbol{u})$ of the sample at low magnification (LM), as illustrated in Figure 2A (here $\boldsymbol{u} = (x, y) \in \mathbb{R}^2$ is a two-dimensional vector that denotes the position on the specimen);
> 2) From this overview image, determine the image coordinates $\boldsymbol{u}_i$ of sub-areas of the overview image to be recorded at high magnification (the first interesting sub-area $\boldsymbol{u}_1$ is shown with an "X" in Figure 2A);
> 3) Shift the beam using the deflectors such that the center of the HM image is at the determined coordinates of the first interesting sub-area $\boldsymbol{u}_1$ (the intended shift is illustrated by the arrow in Figure 2A);
> 4) Record an image of the target area at high magnification (HM), illustrated in Figure 2B.

In the ideal scenario (which the traditional art assumes), the center of this HM image corresponds to the center of the interesting area $\boldsymbol{u}_1$. However, for various reasons, there can be an apparent shift between these centers. This can be caused by:

> i. Incorrect calibration of magnification of the LM and/or HM image;

ii. Incorrect orientation of the LM and/or HM image;
iii. Distortions in the LM image, which may be:

a. Due to optical aberrations, and/or
b. Due to camera imperfections;

iv. inaccurate targeting due to non-flatness of the sample, as explained below;
v. drift of the stage; and
vi. other unspecified factors.

To account for such targeting errors, the following steps may be added to the method:
5) Use cross-correlation, a neural network or AI to determine the apparent shift or the "targeting error" $\Delta_1$ between the center of the HM image and the center of the first target area $\boldsymbol{u}_1$, as illustrated by the arrow in Figure 2B.

When all target areas $\boldsymbol{u}_i$ have been visited and recorded, an error map $\Delta$ is provided for the overview image. This error map should be smooth (in other words, there are no sudden changes) because the underlying causes i, ii, iii, iv, v all create smoothly varying error maps. Because of this smoothness, the already recorded HM images and their errors can be used to create a map and this map may be interpolated and/or extrapolated to not-yet acquired areas. Thus, while image acquisition is still ongoing, the already recorded HM images may be used to predict what correction should be applied to the beam shift for recording the next HM images:

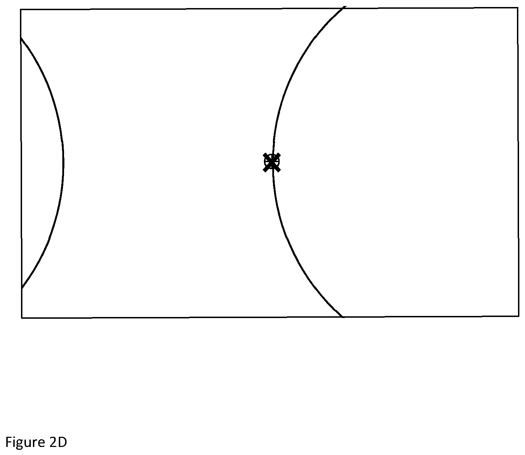

6) Use the latest apparent shift / targeting error $\Delta_1$ to refine the error map;
7) Use the refined error map to predict the targeting error $\Delta_{i+1}$ at the next target location $\boldsymbol{u}_{i+1}$ and calculate a calibrated target location $\boldsymbol{u}_{i+1}^{cal}$ to account for the predicted targeting error, as illustrated by the arrow in Figure 2C (assuming the same target location $\boldsymbol{u}_1$, for illustrative purposes only);
8) Shift the beam to the next calibrated target location and capture the next image at high magnification (HM), as illustrated in Figure 2D;
9) Repeat steps 4 to 8 until all target sub-areas have been imaged.

Some example methods change the order in which the target areas $\boldsymbol{u}_i$ are recorded, such that the error map can be created, updated, and extrapolated in an optimal way. For example, the target areas $\boldsymbol{u}_i$ may be visited along a spiral path, spiralling out from the center of the LM overview (or "reference") image.

The error map $\Delta(\boldsymbol{u})$ may be written as a sum of basis functions $B_k(\boldsymbol{u})$. In other words, $\Delta(\boldsymbol{u}) = \Sigma_k \, \boldsymbol{c}_k B_k(\boldsymbol{u})$ The coefficients $\boldsymbol{c}_k$ are initially all zero (so no errors) and are determined and fine-tuned using the measured errors $\Delta_i$.

In one example, Zernike polynomials may be used for the basis functions. These functions may be useful for describing optical aberrations. Alternatively or additionally, 2D spline functions may be used for the basis functions. These functions may be better suited for describing specimen non-flatness.

The method can be extended by an extra step 2a (after step 2: acquiring the overview image at LM and before step 3: acquiring the final images at HM) in which a map at some intermediate magnification MM is recorded (for example LM=100x, MM=6,000x, HM=100,000x) to measure and build a first approximation of $\Delta(\boldsymbol{u})$.

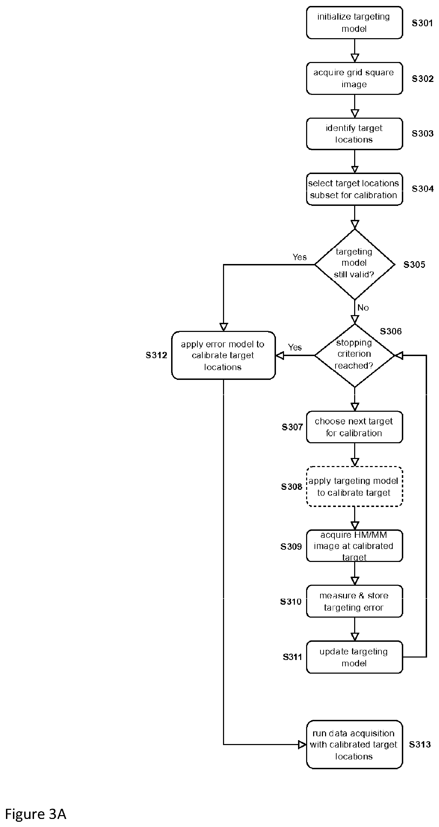

Figure 3A illustrates a flowchart for "calibration method 1" and "calibration method 2". The steps illustrated in the flowchart are explained individually below.

A targeting model is initialized at step S301. This initialization may be the identity map, i.e., the model that, given any target location, returns a calibrated target location that is the same as the given target location. Alternatively, the initialization may be done by copying parameters from a model fit on targets from another grid square.

A grid square image is acquired at step S302.

Based on the grid square image acquired at step S302, target locations are identified at step S303. This is typically done by a hole finding algorithm but may be assisted or performed entirely by a human operator.

At step S304, subset of target locations is selected from the target locations identified at step S303. This selection is done such that the area of foil holes (e.g., the convex hull of all target locations) is covered with selected points in such a way that a model with small modeling error (e.g., less than 50 nm at any foil hole location) can be fit with the fewest selected points possible. Typically, for smooth targeting error fields, this can be achieved by a spatially uniform coverage using at least 10 locations in a grid square with 50 um side length. Alternatively, the selection may be done randomly from each of a chosen number of bins, where each bin contains a chosen number of locations in a chosen order. For example, the order of locations may be the order of acquisition as set by the acquisition software.

At step S305, a calibration criterion decides whether the current targeting model is still valid. This assessment may be done based whether the optical settings have changed compared to the acquisition of the images used to fit the current model. The assessment may further be based on prior knowledge on the current grid square as compared to the grid square on which the current model was fit. For example, this prior knowledge may include an estimate of height deviation, level of contamination, cracks, etc.

If the targeting model evaluated at step S305 is invalid, the method enters a loop. At the beginning of the loop, a stopping criterion is checked at step S306. This stopping criterion may be the logical OR of "no next target available?" and further criteria. These further criteria may be based on a confidence value that the current targeting model has an error smaller than a chosen value.

At step S307, a next target location is selected as current target location from the subset 4 of target location.

In "calibration method 2", the current targeting model is applied to the current target location to produce a calibrated target location at step S308. In "calibration method 1", the calibrated target location is chosen to be the current target location.

At step S309, an image at intermediate (MM) or high (HM) magnification is acquired at the calibrated target location using image shift to deflect the beam to be centered at the calibrated target location.

The targeting error at the calibrated target location is measured at step S310 by comparing a crop of the grid square image at the calibrated target location with the image acquired at step S309. This measurement may be performed using image processing techniques, e.g., feature tracking, optical flow, feature recognition, or image registration to detect the shift between the two images. The measured targeting error at the calibrated target location is stored.

A new targeting model is fit to data pairs ($u_i$, $\Delta_i$) available so far, where for the $i$-th location, $u_i \in \mathbb{R}^2$ is the calibrated target location, and $\Delta_i \in \mathbb{R}^2$ is measured targeting error. This new targeting model may be taken to be the new current targeting model for the next iteration. This model update may be subject to model quality checks. For example, the new model may be rejected if the parameters are outside a chosen range of valid parameters. The new model may also be rejected based on quality metrics, e.g., quality of fit on the measured targeting errors for a chosen error metric.

At step S312, which is reached either if the model evaluated at step S305 is still valid or if the stopping criterion checked at step S306 has been reached, the current targeting model is applied to all target locations selected at step S304, resulting in calibrated locations for all target locations.

The conventional data acquisition method is run at step S313, using the calibrated target locations from step S312.

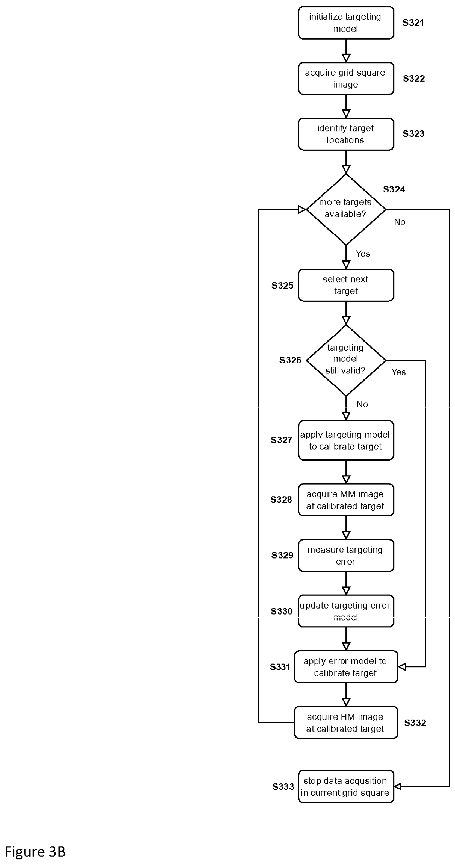

Figure 3B illustrates a flowchart for "calibration method 3". The steps illustrated in the flowchart are explained individually below.

A targeting model is initialized at step S321. This initialization may be the identity map, i.e., the model that, given any target location, returns a calibrated target location that is the same as the given target location. Alternatively, the initialization may be done by copying parameters from a model fit on targets from another grid square.

At step S322, a grid square image is acquired.

Based on the grid square image acquired at step S322, target locations are identified at step S323. This is typically done by a hole finding algorithm but may be assisted or performed entirely by a human operator.

At step S324, it is checked whether further targets remain to be processed for acquisition. If not, the data acquisition for the current grid square is finished and the method progresses to step S313. The application may decide to continue acquisition at a next grid square.

If more targets remain to be processed, the next target is selected at step S325.

At step S326, a calibration criterion decides whether the current targeting model is still valid. This assessment may be done based on whether the optical settings have changed compared to the acquisition of the images used to fit the current model. The assessment may further be based on prior knowledge on the current grid square as compared to the grid square on which the current model was fit. For example, this prior knowledge may include an estimate of height deviation, level of contamination, cracks, etc. The assessment may further be based on the time since the last calibration, a total drift estimation, or a combination thereof.

If the current model is valid, it is immediately applied to calibrate the current target location at step S331. Otherwise, the current model is applied to the current target, producing a preliminary calibrated target location at step S327.

At step S328, an image at intermediate magnification (MM) is acquired at the preliminary calibrated target location using image shift to deflect the beam to be centered at the preliminary calibrated target location.

The targeting error at the preliminary calibrated target location is measured at step S329 by comparing a crop of the grid square image at the preliminary calibrated target location with the image acquired at step S328. This measurement may be performed using image processing techniques, e.g., feature tracking, optical flow, feature recognition, or image registration to detect the shift between the two images. The measured targeting error at the preliminary calibrated target location is stored.

At step S330, a new targeting model is fit to data pairs ($u_i$, $\Delta_i$) available so far, where for the $i$-th location, $\underline{u}_i \in \mathbb{R}^2$ is the preliminary calibrated target location, and $\Delta_i \in \mathbb{R}^2$ is the measured targeting error. This new targeting model may be taken to be the new current targeting model for the next iteration. This model update may be subject to model quality checks. For example, the new model may be rejected if the parameters are outside a chosen range of valid parameters. The new model may also be rejected based on quality metrics, e.g., quality of fit on the measured targeting errors for a chosen error metric.

The current targeting model is applied to the target location, producing a calibrated target location at step S331.

At step S332, a high magnification (HM) image is acquired at the calibrated target location.

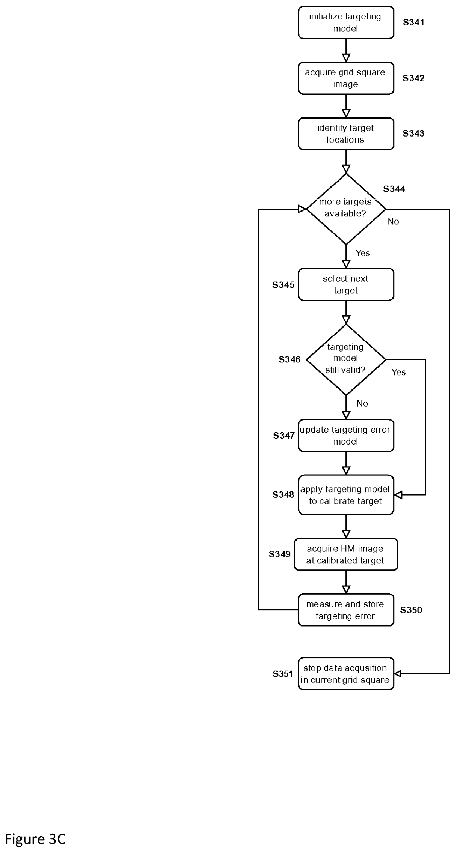

Figure 3C illustrates a flowchart for "calibration method 4". The steps illustrated in the flowchart are explained individually below.

A targeting model is initialized at step S341. This initialization may be the identity map, i.e., the model that, given any target location, returns a calibrated target location that is the same as the given target location. Alternatively, the initialization may be done by copying parameters from a model fit on targets from another grid square.

A grid square image is acquired at step S342.

Based on the grid square image acquired at step S342, target locations are identified at step S343. This is typically done by a hole finding algorithm but may be assisted or performed entirely by a human operator.

At step S344, it is checked whether further targets remain to be processed for acquisition. If not, the data acquisition for the current grid square is finished at step S351. The application may decide to continue acquisition at a next grid square.

If more targets remain to be processed, the next target is selected at step S345.

At step S346, a calibration criterion decides whether the current targeting model is still valid. This assessment may be done based whether the optical settings have changed compared to the acquisition of the images used to fit the current model. The assessment may further be based on prior knowledge on the current grid square as compared to the grid square on which the current model was fit. For example, this prior knowledge may include an estimate of height deviation, level of contamination, cracks, etc. The assessment may further be based on the time since the last calibration, a total drift estimation, or a combination thereof.

If the current model is valid, it is immediately applied to calibrate the current target location at step S348. Otherwise, at step S347, a new targeting model is fit to data pairs ($\boldsymbol{u}_i$, $\Delta_i$) available so far, where for the $i$-th location, $\boldsymbol{u}_i \in \mathbb{R}^2$ is the calibrated target location, and $\Delta_i \in \mathbb{R}^2$ is the measured targeting error. This new targeting model may be taken to be the new current targeting model for the next iteration. This model update may be subject to model quality checks. For example, the new model may be rejected if the parameters are outside a chosen range of valid parameters. The new model may also be rejected based on quality metrics, e.g., quality of fit on the measured targeting errors for a chosen error metric.

The current targeting model is applied to the target location, producing a calibrated target location at step S348.

At step S349, a high magnification (HM) image is acquired at the calibrated target location.

The targeting error at the calibrated target location is measured at step S350 by comparing a crop of the grid square image at the calibrated target location with the image acquired at step S349. This measurement may be performed using image processing techniques, e.g., feature tracking, optical flow, hole recognition, or image registration to detect the shift between the two images. The measured targeting error at the preliminary calibrated target location is stored.

In a proposed method illustrated in a further specific example, variations in the sample height may be accounted for by the model. One way in which this may be achieved is by adding the dimension z to the targeting algorithm (the sample height deviation from the "imaginary targeting plane", as explained below).

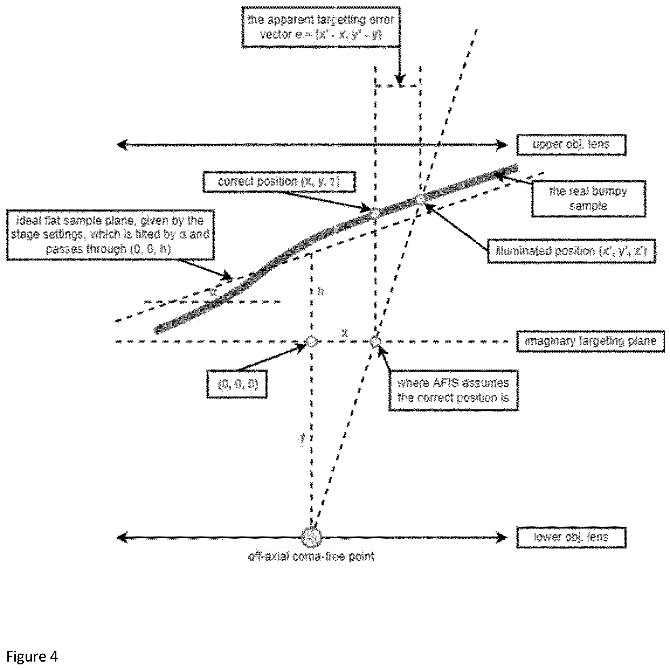

A geometrical model to determine the targeting error is illustrated in Figure 4. This model takes the sample height variation into account. For simplicity, this diagram assumes that the coma-free pivot point coincides with the centre of the objective lens.

The apparent targeting error vector is defined as $\Delta = \boldsymbol{u}' - \boldsymbol{u}$. The x-component and y-component of these vectors are denoted as $\Delta = (e_x, e_y)$, $\boldsymbol{u} = (x, y)$, and $\boldsymbol{u}' = (x', y')$. When the sample is flat and overlapping with the "ideal flat sample plane", the illuminated position is given by equations (1a) and (1b):

$$x' = x + e_x \tag{1a}$$

$$z' = h + x \tan(\alpha) + e_x \tan(\alpha) \tag{1b}$$

Comparing similar triangles, we conclude in equation (2) that:

$$f/x = (h + x \tan(\alpha) + e_x \tan(\alpha))/e_x \tag{2}$$

The targeting error $e_x$ can therefore be calculated using equation (3) as:

$$e_x = (xh + x^2\tan(\alpha))/(f\text{-}x\,\tan(\alpha)) \qquad\qquad (3)$$

In the specific example, the proposed method initially approximates the sample height using the above equation, which assumes that the sample is flat and overlapping with the "ideal flat sample plane". The method will switch to a more accurate height extrapolation scheme which takes the sample height variation into account, once there are enough defocus values from neighbouring positions available. This approach assumes local smoothness of the SPA sample. The specific proposed method will continue to monitor the error (with neural network-based image recognition) and on the fly refine the prediction of the sample height using a smooth function.

Enhancements are provided by the proposed methods (which may be referred to as 3D-AFIS), compared to conventional techniques, which include:

taking the sample height variation into account,
using extrapolation for sample height prediction,
on-the-fly monitoring and correction of remaining errors.

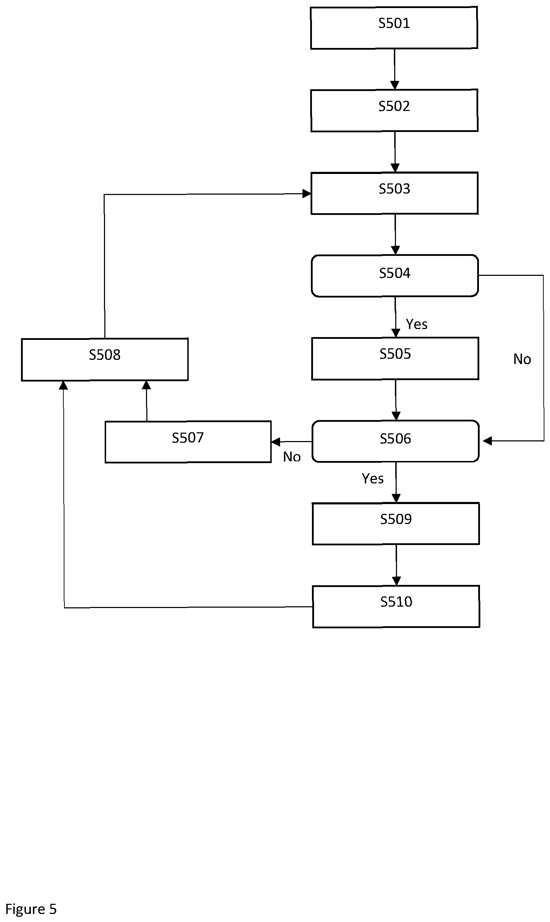

A detailed example is illustrated in the flowchart in Figure 5. The method starts at step S501.

Conventional beam control methods are performed at step S502.

At step S503, the system acquires the next HM image (for example, using a "data acquisition" pre-set function, such as that provided in the EPU software described above).

At step S504, the system determines whether a foil hole edge is visible. If yes, the method proceeds to step S505. If no, the method proceeds to step S506.

At step S505, the system first determines **u'** by:

1. image segmentation to outline the edge
2. geometrical analysis

Second, the system calculates the error vector using equation (4):

$$\mathbf{e} = (e_x, e_y) = \mathbf{u'} - \mathbf{u} - \text{predicted\_optical\_error}(\mathbf{u'}) \qquad\qquad (4)$$

Here the predicted optical error is set to (0, 0), at the start of the session by default. We also assume the optical error introduced by z' change is ignorable, which is valid considering the small beam tilt angle.

At step S506, the system determines whether two criteria are met:

More than a threshold "M" number of HM images acquired with measured defocus
More than a threshold "N" number of HM images with foil hole edge analysed

M & N are positive integer parameters set by the user to ensure robustness. They can be decided based on the experiment type.

If both criteria are met, the method proceeds to step S509. If one or both criteria are not met, the method proceeds to step S507.

At step S507, the system assumes the sample is flat and estimates z using $\alpha$.

At step S508, the system performs improved beam control, where x, y, z and a function predict_optical_error( . , . ) is used to predict the beam/image tilt/shift for the next HM area. It will be the same when z = 0.

At step S509, the system extrapolates and determines z using all x, y, b, and z from previously acquired HM images, using f and $\alpha$ as prior known parameters. Here, b is defined as the difference between the Thon ring measured defocus and the objective lens defocus. It measures the sample height deviation from the "imaginary targeting plane", with contributions from the local deviation of the height of the sample from the ideal flat sample plane and the tilt of the sample.

Aberrations which are of odd order in beam angle (such as focus and astigmatism which are of first order, and spherical aberration which is of third order) may be observed because these odd-ordered aberrations affect the so-called "Thon rings" in the Fourier transform of the image (Thon rings are rings or ellipses of zero intensity in the Fourier transform). The Fourier transform of the image may be observed in real-time and the controls for focus and astigmatism may be adjusted in order to optimize the image resolution. The difference between the Thon ring measured defocus and the objective lens defocus may be determined by analysing the position and ellipticity of the Thon rings.

At step S510, the system fits & updates the predict_optical_error( . , . ) function with the difference between the measured **e** and the predicted **e** using equation (3) above.

In this method, optical errors are addressed and accounted for in the model, without the necessity of knowing the physical root cause.

*Experimental Results*

The targeting inaccuracy has been investigated for a typical SPA sample and for a tilted gold grid sample. First, 'raw' data were collected for the whole grid square (with no correction). To do so, the following steps were performed:

> set the image shift range such that a whole grid square is covered,
> switch off scaling and rotation calibration in the software,
> collect HM images of all foil holes in the whole grid square,
> evaluate the 'raw' targeting errors (i.e., the difference between positions in the sample map, as recorded in LM, and the position as measured from the HM images).

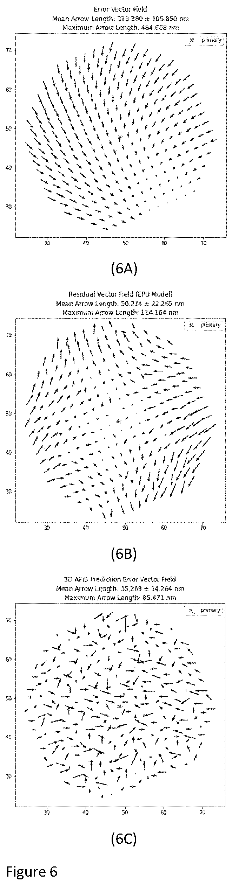

Figure 6 illustrates targeting errors measured experimentally on a life sciences sample. The error measurements were obtained by targeting all reachable locations on a grid square with image shift without applying any correction. Each arrow in the vector field plots shows one error measurement, where the start of the vector is placed at the target location for that measurement, and the tip of the vector is displaced from the start of the vector by the measured error.

Figure 6A illustrates the raw error vector field (no correction applied). Figure 6B illustrates the residual error vector field after emulating the scaling and rotation calibration as performed in known techniques (~50 % of areas have >= 50 nm error). Figure 6C illustrates the residual error vector field after emulating specific example techniques as proposed in this application (~7 % of areas have >= 50 nm error).

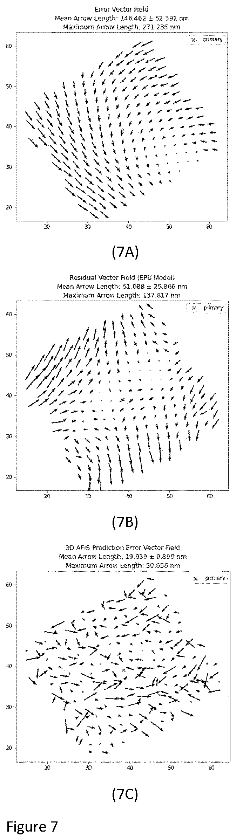

Figure 7 illustrates targeting errors on a gold grid sample tilted by 30°. Figure 7A illustrates the raw error vector field (no correction). Figure 7B illustrates the residual error vector field after emulating scaling and rotation calibration as performed in known techniques (~52 % of areas have >= 50 nm error). Figure 7C illustrates the residual error vector field after emulating specific example techniques as proposed in this application (< 1 % of areas have >= 50 nm error).

The 'raw' targeting errors are shown in Figures 6A and 7A.

The performance of the known approach is illustrated in Figures 6B and 7B. These figures illustrate corrections of the raw targeting errors with rotation and linear scaling, using known techniques.

Finally, the same raw targeting errors are corrected using a specific method as described in this application: This is done by looping over the foil holes in acquisition order and predicting the targeting error from the closest already acquired foil hole. Results are shown in Figures 6C and 7C. In all cases, the current approach proved to be insufficient to reach 50 nm or better global accuracy, whereas accuracy was better than 50 nm using the proposed techniques for most foil holes.

It is worth noting that part of the remaining errors illustrated in Figures 6C and 7C may be due to inaccurate measurement of the foil hole centres, rather than actual errors after correction using the proposed methods.

Phase aberration and apparent astigmatism of images may be determined using techniques known as "Thon ring fitting", which measure the position and ellipticity of the Thon rings in the Fourier transform of the image. A contrast transfer function (CTF) mathematically describes how aberrations affect the image and may be used to determine parameters quantifying the phase aberration and apparent astigmatism (among other parameters, such as defocus).

It is desirable that the conductive supporting film does not appear inside the camera FOV, so that all of the captured image is useful. However, the software refines the model based on residual targeting errors that are determined by observing discrepancies between the expected and observed positions of the foil hole edge. In order to observe/measure these discrepancies, the foil hole edge needs to be within the FOV. One solution is to take more images at the same HM magnification: initial images including the foil hole edge to refine the model and subsequent images that do not include the foil hole edge. In another solution, auxiliary HM images may be obtained at slightly lower magnification, at the same time as the high-magnification HM images. In this way, the FOV of the camera is widened to see the edge of the foil hole, at the same time as capturing the image that is free of the foil hole edge. The high-magnification HM image (no foil hole edge) and the low-magnification HM image (including a foil hole edge) share the same targeting error because most of the microscope settings are the same. Only the final magnification is adjusted and is only adjusted slightly.

As used herein, including in the claims, unless the context indicates otherwise, singular forms of the terms herein are to be construed as including the plural form and vice versa. For instance, unless the context indicates otherwise, a singular reference herein including in the claims, such as "a" or "an" (such as an analogue to digital convertor) means "one or more" (for instance, one or more analogue to digital convertor). Throughout the description and claims of this disclosure, the words "comprise", "including", "having" and "contain" and variations of the words, for example "comprising" and "comprises" or similar, mean "including but not limited to", and are not intended to (and do not) exclude other components.

Although embodiments according to the disclosure have been described with reference to particular types of devices and applications (particularly transmission electron microscopy, single particle analysis and cryogenic electron microscope) and the embodiments have particular advantages in such case, as discussed herein, approaches according to the disclosure may be applied to other types of device and/or application. The specific structural details of the microscope, whilst potentially advantageous (especially in view of known electron microscope system constraints and capabilities), may be varied significantly to arrive at devices with similar or identical operation. Each feature disclosed in this specification, unless stated otherwise, may be replaced by alternative features serving the same, equivalent or similar purpose. Thus, unless stated otherwise, each feature disclosed is one example only of a generic series of equivalent or similar features.

The above techniques are described in relation to Transmission Electron Microscopy (TEM). It should be understood that the present techniques may be useful when applied to sample alignment in other charged particle beam microscopy systems, such as a scanning tunnelling electron microscopy (STEM) system, scanning electron microscopy (SEM) system, dual beam microscopy system, and/or an ion-based microscope. The present discussion of TEM imaging is provided merely as an example of one suitable imaging modality. The techniques may also be used with a collimated incident beam.

The use of any and all examples, or exemplary language ("for instance", "such as", "for example" and like language) provided herein, is intended merely to better illustrate the invention and does not indicate a limitation on the scope of the invention unless otherwise claimed. No language in the specification should be construed as indicating any non-claimed element as essential to the practice of the invention.

Any steps described in this specification may be performed in any order or simultaneously unless stated or the context requires otherwise.

All of the aspects and/or features disclosed in this specification may be combined in any combination, except combinations where at least some of such features and/or steps are mutually exclusive. As described herein, there may be particular combinations of aspects that are of further benefit, such the aspects of determining a set of compensation parameters and applying a set of compensation parameters to measurements. In particular, the preferred features of the invention are applicable to all aspects of the invention and may be used in any combination. Likewise, features described in non-essential combinations may be used separately (not in combination).

Where the application refers to "odd" and "even" order aberrations, this is a reference to the order of the angular dependence (rather than the phase dependence). In other words, odd order aberrations include focus and astigmatism which are of first order, and spherical aberration which is of third order. Even order aberrations may include on-axial and off-axial coma.

## Claims

1. A method of automated data acquisition for a transmission electron microscope (M), the method comprising:

   obtaining a reference image of a sample (S) at a first magnification;
   for each of a first plurality of target locations identified in the reference image:

   steering an electron beam (B) of the transmission electron microscope (M) to the target location,
   obtaining a calibration image of the sample (S) at a second magnification greater than the first magnification, and
   using image processing techniques to identify an apparent shift between an expected position of the target location in the calibration image and an observed position of the target location in the calibration image,

   training a non-linear model using the first plurality of target locations and the corresponding apparent shifts, wherein the non-linear model is configured to predict an apparent shift when a given target location is input into the beam steering process;
   based on the non-linear model, calculating a calibrated target location for a next target location;
   steering the electron beam (B) to the calibrated target location and obtaining an image at a third magnification greater than the first magnification.

2. The method of any preceding claim, further comprising:

   ordering the first plurality of target locations such that a magnitude of each target location increases from start to end, wherein the magnitude of each target location is a magnitude of a vector from a centre of the reference image to the target location or a distance from an optical axis of the transmission electron microscope to the target location; and/or
   ordering the first plurality of target locations such that an angle of the target location changes smoothly from start to end, wherein the angle of each target location is an angle between a defined axis and a vector from a centre of the reference image to the target location;

wherein, for each of the first plurality of target locations identified in the reference image, the method further comprises calculating a calibrated target location, based on the non-linear model,

wherein steering the electron beam (B) to the target location comprises inputting the calibrated target location into a beam steering process,

wherein, the method further comprises updating the non-linear model after identifying each apparent shift, based on the calibrated target location and the corresponding apparent shift.

3. The method of any preceding claim, wherein the next target location is one of a second plurality of target locations and the method comprises, for each of the second plurality of target locations:

calculating a calibrated target location, based on the non-linear model,
steering the electron beam (B) to the calibrated target location, and
obtaining an image of the sample (S) at the third magnification.

4. The method of claim 3, further comprising:
for each of the second plurality of target locations:

determining whether the non-linear model is still valid, based on one or more predetermined criteria, wherein the predetermined criteria comprise one or more of:

a number of acquisitions since a previous calibration exceeding a certain pre-defined number of acquisitions;
a time elapsed since the previous calibration exceeding a certain pre-defined time interval;
measured targeting errors exceeding a certain pre-defined maximum targeting error; and
optical settings have changed compared to optical settings during acquisition of images used to fit the non-linear model;

if recalibration is required, obtaining an image of the sample (S) at the second magnification, using image processing techniques to identify an apparent shift between an expected position of the target location in the image and an observed position of the target location in the image, updating the non-linear model based on the apparent shift.

5. The method of claim 3, further comprising:
for each of the second plurality of target locations:

determining whether the non-linear model is still valid, based on one or more predetermined criteria;
if recalibration is required, using image processing techniques to identify an apparent shift between an expected position and an observed position of the immediately preceding target location from the second plurality of target locations in the corresponding image obtained at the third magnification, updating the non-linear model based on the calibrated target location and the corresponding apparent shift.

6. The method of any preceding claim, wherein the first plurality of target locations are selected such that the target locations and identified apparent shifts are sufficient for training the non-linear model, such that the non-linear model is accurate at the second plurality of target locations.

7. The method of any preceding claim, further comprising:

identifying a third plurality of target locations that are of interest in the reference image;
selecting the first plurality of target locations as a subset of the third plurality of target locations.

8. The method of any preceding claim wherein, for each of the first plurality of target locations, the next target location, the second plurality of target locations and/or the third plurality of target locations:

the sample (S) comprises one or more features suitable for image registration in proximity to each target location, such that one or more of the features are visible in an image obtained at the target location, and/or
each target location is located within a threshold distance from an optical axis of the microscope, such that the target location is reachable by image shift.

9. The method of any preceding claim, further comprising:

obtaining a second reference image of the sample (S) at the first magnification; and
identifying a second plurality of target locations in the second reference image.

10. The method of any preceding claim, wherein the non-linear model is configured to estimate an apparent shift of a feature of the sample (S) in an image obtained by steering the electron beam (B) to the target location.

11. The method of any preceding claim, wherein steering the electron beam (B) comprises adjusting a tilt and/or shift of the electron beam (B), preferably by:

adjusting the incident electron beam (B), and/or
adjusting the transmitted electron beam (B).

12. The method of any preceding claim, wherein using image processing techniques to identify an apparent shift between the expected position of the target location in the calibration image and the observed position of the target location in the calibration image comprises:

determining the expected position of the feature in the calibration image, using a steering model;
identifying the feature in the calibration image at an observed position;
determining the apparent shift as the difference between the expected position and the observed position.

13. The method of any preceding claim further comprising:

obtaining a defocus measurement for one or more calibration images; and
updating the non-linear model based on the defocus measurement.

14. A transmission electron microscope apparatus (M) configured to perform the method of any of claims 1 to 13.

15. Computer software comprising instructions that, when executed on a processor of a transmission electron microscope apparatus (M), cause the transmission electron microscope apparatus (M) to perform the method of any of claims 1 to 13.


**Patentansprüche**

1. Verfahren zur automatisierten Datenerfassung für ein Transmissionselektronenmikroskop (M), das Verfahren umfassend:

Erhalten eines Referenzbildes einer Probe (S) bei einer ersten Vergrößerung;
für jede einer ersten Vielzahl von Zielpositionen, die in dem Referenzbild identifiziert sind:

Lenken eines Elektronenstrahls (B) des Transmissionselektronenmikroskops (M) zu der Zielposition,
Erhalten eines Kalibrierungsbildes der Probe (S) bei einer zweiten Vergrößerung, die größer ist als die erste Vergrößerung, und
Verwendung von Bildverarbeitungstechniken zur Identifizierung einer scheinbaren Verschiebung zwischen einer erwarteten Position der Zielposition in dem Kalibrierungsbild und einer beobachteten Position der Zielposition in dem Kalibrierungsbild,
Trainieren eines nichtlinearen Modells unter Verwendung der ersten Vielzahl von Zielpositionen und der entsprechenden scheinbaren Verschiebungen, wobei das nichtlineare Modell konfiguriert ist, um eine scheinbare Verschiebung vorherzusagen, wenn eine gegebene Zielposition in den Strahlenlenkungsprozess eingegeben wird;
basierend auf dem nichtlinearen Modell, Berechnen einer kalibrierten Zielposition für eine nächste Zielposition;
Lenken des Elektronenstrahls (B) zu der kalibrierten Zielposition und Erhalten eines Bildes bei einer dritten Vergrößerung, die größer ist als die erste Vergrößerung.

2. Verfahren nach einem der vorstehenden Ansprüche, ferner umfassend:

Ordnen der ersten Vielzahl von Zielpositionen derart, dass eine Größe jeder Zielposition von Anfang bis Ende zunimmt, wobei die Größe jeder Zielposition eine Größe eines Vektors von einem Zentrum des Referenzbildes zu der Zielposition oder ein Abstand von einer optischen Achse des Transmissionselektronenmikroskops zu der Zielposition ist; und/oder

Ordnen der ersten Vielzahl von Zielpositionen derart, dass sich ein Winkel der Zielposition gleichmäßig von Anfang bis Ende ändert, wobei der Winkel jeder Zielposition ein Winkel zwischen einer definierten Achse und einem Vektor von einem Zentrum des Referenzbildes zu der Zielposition ist;

wobei das Verfahren für jede der ersten Vielzahl von Zielpositionen, die in dem Referenzbild identifiziert sind, ferner Berechnen einer kalibrierten Zielposition basierend auf dem nichtlinearen Modell umfasst,

wobei das Lenken des Elektronenstrahls (B) zu der Zielposition Eingeben der kalibrierten Zielposition in einen Strahlenlenkungsprozess umfasst,

wobei das Verfahren ferner Aktualisieren des nichtlinearen Modells nach dem Identifizieren jeder scheinbaren Verschiebung basierend auf der kalibrierten Zielposition und der entsprechenden scheinbaren Verschiebung umfasst.

3.  Verfahren nach einem der vorstehenden Ansprüche, wobei die nächste Zielposition eine aus einer zweiten Vielzahl von Zielpositionen ist und das Verfahren umfasst, für jede der zweiten Vielzahl von Zielpositionen:

Berechnen einer kalibrierten Zielposition basierend auf dem nichtlinearen Modell,
Lenken des Elektronenstrahls (B) zu der kalibrierten Zielposition, und
Erhalten eines Bildes der Probe (S) bei der dritten Vergrößerung.

4.  Verfahren nach Anspruch 3, ferner umfassend:
für jede der zweiten Vielzahl von Zielpositionen:
Bestimmen, ob das nichtlineare Modell noch gültig ist, basierend auf einem oder mehreren vorbestimmten Kriterien, wobei die vorbestimmten Kriterien eines oder mehrere umfassen von:

einer Anzahl von Erfassungen seit einer vorherigen Kalibrierung, die eine bestimmte vordefinierte Anzahl von Erfassungen überschreitet;
einer seit der vorherigen Kalibrierung verstrichenen Zeit, die ein bestimmtes vordefiniertes Zeitintervall überschreitet;
gemessenen Zielungsfehlern, die einen bestimmten vordefinierten maximalen Zielungsfehler überschreiten; und
optische Einstellungen haben sich im Vergleich zu optischen Einstellungen während der Erfassung von Bildern, die zur Anpassung des nichtlinearen Modells verwendet wurden, geändert;
falls eine Neukalibrierung erforderlich ist, Erhalten eines Bildes der Probe (S) bei der zweiten Vergrößerung, Verwenden von Bildverarbeitungstechniken zur Identifizierung einer scheinbaren Verschiebung zwischen einer erwarteten Position der Zielposition in dem Bild und einer beobachteten Position der Zielposition in dem Bild, Aktualisieren des nichtlinearen Modells basierend auf der scheinbaren Verschiebung.

5.  Verfahren nach Anspruch 3, ferner umfassend:
für jede der zweiten Vielzahl von Zielpositionen:

Bestimmen, ob das nichtlineare Modell noch gültig ist, basierend auf einem oder mehreren vorbestimmten Kriterien;
falls eine Neukalibrierung erforderlich ist, unter Verwendung von Bildverarbeitungstechniken zur Identifizierung einer scheinbaren Verschiebung zwischen einer erwarteten Position und einer beobachteten Position der unmittelbar vorhergehenden Zielposition aus der zweiten Vielzahl von Zielpositionen in dem entsprechenden bei der dritten Vergrößerung erhaltenen Bild, Aktualisieren des nichtlinearen Modells basierend auf der kalibrierten Zielposition und der entsprechenden scheinbaren Verschiebung.

6.  Verfahren nach einem der vorstehenden Ansprüche, wobei die erste Vielzahl von Zielpositionen so ausgewählt wird, dass die Zielpositionen und identifizierten scheinbaren Verschiebungen für das Trainieren des nichtlinearen Modells ausreichen, so dass das nichtlineare Modell bei der zweiten Vielzahl von Zielpositionen genau ist.

7.  Verfahren nach einem der vorstehenden Ansprüche, ferner umfassend:

Identifizieren einer dritten Vielzahl von Zielpositionen, die in dem Referenzbild von Interesse sind;
Auswählen der ersten Vielzahl von Zielpositionen als eine Teilmenge der dritten Vielzahl von Zielpositionen.

8. Verfahren nach einem der vorstehenden Ansprüche, wobei für jede der ersten Vielzahl von Zielpositionen, die nächste Zielposition, die zweite Vielzahl von Zielpositionen und/oder die dritte Vielzahl von Zielpositionen:

die Probe (S) ein oder mehrere Merkmale umfasst, die für eine Bildregistrierung in der Nähe jeder Zielposition geeignet sind, so dass eines oder mehrere der Merkmale in einem an der Zielposition erhaltenen Bild sichtbar sind, und/oder
jede Zielposition innerhalb einer Schwellenwertentfernung von einer optischen Achse des Mikroskops angeordnet ist, so dass die Zielposition durch Bildverschiebung erreichbar ist.

9. Verfahren nach einem der vorstehenden Ansprüche, ferner umfassend:

Erhalten eines zweiten Referenzbildes der Probe (S) bei der ersten Vergrößerung; und
Identifizieren einer zweiten Vielzahl von Zielpositionen in dem zweiten Referenzbild.

10. Verfahren nach einem der vorstehenden Ansprüche, wobei das nichtlineare Modell konfiguriert ist, um eine scheinbare Verschiebung eines Merkmals der Probe (S) in einem Bild zu schätzen, das durch Lenken des Elektronenstrahls (B) zu der Zielposition erhalten wird.

11. Verfahren nach einem der vorstehenden Ansprüche, wobei das Lenken des Elektronenstrahls (B) Einstellen einer Neigung und/oder Verschiebung des Elektronenstrahls (B) umfasst, vorzugsweise durch:

Einstellen des einfallenden Elektronenstrahls (B), und/oder
Einstellen des übertragenen Elektronenstrahls (B).

12. Verfahren nach einem der vorstehenden Ansprüche, wobei die Verwendung von Bildverarbeitungstechniken zur Identifizierung einer scheinbaren Verschiebung zwischen der erwarteten Position der Zielposition in dem Kalibrierungsbild und der beobachteten Position der Zielposition in dem Kalibrierungsbild umfasst:

Bestimmen der erwarteten Position des Merkmals in dem Kalibrierungsbild unter Verwendung eines Lenkmodells;
Identifizieren des Merkmals in dem Kalibrierungsbild an einer beobachteten Position;
Bestimmen der scheinbaren Verschiebung als Differenz zwischen der erwarteten Position und der beobachteten Position.

13. Verfahren nach einem der vorstehenden Ansprüche, ferner umfassend:

Erhalten einer Defokussierungsmessung für ein oder mehrere Kalibrierungsbilder; und
Aktualisieren des nichtlinearen Modells basierend auf der Defokussierungsmessung.

14. Transmissionselektronenmikroskopeinrichtung (M), die zum Durchführen des Verfahrens nach einem der Ansprüche 1 bis 13 konfiguriert ist.

15. Computersoftware, die Anweisungen umfasst, die, wenn sie auf einem Prozessor einer Transmissionselektronenmikroskopeinrichtung (M) ausgeführt werden, die Transmissionselektronenmikroskopeinrichtung (M) veranlassen, das Verfahren nach einem der Ansprüche 1 bis 13 durchzuführen.

**Revendications**

1. Procédé d'acquisition automatisée de données pour un microscope électronique à transmission (M), le procédé comprenant :

l'obtention d'une image de référence d'un échantillon (S) à un premier grossissement ;
pour chacun d'une première pluralité d'emplacements cibles identifiés dans l'image de référence :

l'orientation d'un faisceau électronique (B) du microscope électronique à transmission (M) vers l'emplacement cible,
l'obtention d'une image d'étalonnage de l'échantillon (S) à un deuxième grossissement supérieur au premier grossissement, et

l'utilisation de techniques de traitement d'image pour identifier un décalage apparent entre une position attendue de l'emplacement cible dans l'image d'étalonnage et une position observée de l'emplacement cible dans l'image d'étalonnage,

l'entraînement d'un modèle non linéaire à l'aide de la première pluralité d'emplacements cibles et des décalages apparents correspondants, dans lequel le modèle non linéaire est configuré pour prédire un décalage apparent lorsqu'un emplacement cible donné est entré dans le processus d'orientation de faisceau ;

sur la base du modèle non linéaire, le calcul d'un emplacement cible étalonné pour un emplacement cible suivant ;

l'orientation du faisceau électronique (B) vers l'emplacement cible étalonné et l'obtention d'une image à un troisième grossissement supérieur au premier grossissement.

**2.** Procédé selon l'une quelconque revendication précédente, comprenant en outre :

le classement par ordre de la première pluralité d'emplacements cibles de telle sorte qu'une amplitude de chaque emplacement cible augmente du début à la fin, dans lequel l'amplitude de chaque emplacement cible est une amplitude d'un vecteur allant d'un centre de l'image de référence à l'emplacement cible ou une distance d'un axe optique du microscope électronique à transmission à l'emplacement cible ; et/ou

le classement par ordre de la première pluralité d'emplacements cibles de telle sorte qu'un angle de l'emplacement cible change progressivement du début à la fin, dans lequel l'angle de chaque emplacement cible est un angle entre un axe défini et un vecteur allant d'un centre de l'image de référence à l'emplacement cible ;

dans lequel, pour chacun de la première pluralité d'emplacements cibles identifiés dans l'image de référence, le procédé comprend en outre le calcul d'un emplacement cible étalonné, sur la base du modèle non linéaire,

dans lequel l'orientation du faisceau électronique (B) vers l'emplacement cible comprend l'entrée de l'emplacement cible étalonné dans un processus d'orientation de faisceau,

dans lequel, le procédé comprend en outre la mise à jour du modèle non linéaire après identification de chaque décalage apparent, sur la base de l'emplacement cible étalonné et du décalage apparent correspondant.

**3.** Procédé selon l'une quelconque revendication précédente, dans lequel l'emplacement cible suivant est l'un parmi une deuxième pluralité d'emplacements cibles et le procédé comprend, pour chacun de la deuxième pluralité d'emplacements cibles :

le calcul d'un emplacement cible étalonné, sur la base du modèle non linéaire,

l'orientation du faisceau électronique (B) vers l'emplacement cible étalonné, et

l'obtention d'une image de l'échantillon (S) au troisième grossissement.

**4.** Procédé selon la revendication 3, comprenant en outre :
pour chacun de la deuxième pluralité d'emplacements cibles :
le fait de déterminer si le modèle non linéaire est toujours valide, sur la base d'un ou plusieurs critères prédéterminés, dans lequel les critères prédéterminés comprennent un ou plusieurs parmi :

un nombre d'acquisitions depuis un étalonnage précédent dépassant un certain nombre prédéfini d'acquisitions ;

un temps écoulé depuis l'étalonnage précédent dépassant un certain intervalle de temps prédéfini ;

des erreurs de ciblage mesurées dépassant une certaine erreur de ciblage maximale prédéfinie ; et

des paramètres optiques ayant changé par rapport à des paramètres optiques lors d'une acquisition d'images utilisées pour correspondre au modèle non linéaire ;

si un réétalonnage est nécessaire, l'obtention d'une image de l'échantillon (S) au deuxième grossissement, l'utilisation de techniques de traitement d'image pour identifier un décalage apparent entre une position attendue de l'emplacement cible dans l'image et une position observée de l'emplacement cible dans l'image, la mise à jour du modèle non linéaire sur la base du décalage apparent.

**5.** Procédé selon la revendication 3, comprenant en outre :
pour chacun de la deuxième pluralité d'emplacements cibles :

le fait de déterminer si le modèle non linéaire est toujours valide, sur la base d'un ou plusieurs critères prédéterminés ;

si un réétalonnage est nécessaire, l'utilisation de techniques de traitement d'image pour identifier un décalage apparent entre une position attendue et une position observée de l'emplacement cible immédiatement précédent parmi la deuxième pluralité d'emplacements cibles dans l'image correspondante obtenue au troisième grossissement, la mise à jour du modèle non linéaire sur la base de l'emplacement cible étalonné et du décalage apparent correspondant.

6. Procédé selon l'une quelconque revendication précédente, dans lequel la première pluralité d'emplacements cibles sont sélectionnés de telle sorte que les emplacements cibles et des décalages apparents identifiés sont suffisants pour entraîner le modèle non linéaire, de telle sorte que le modèle non linéaire est précis au niveau de la deuxième pluralité d'emplacements cibles.

7. Procédé selon l'une quelconque revendication précédente, comprenant en outre :

   l'identification d'une troisième pluralité d'emplacements cibles qui présentent un intérêt dans l'image de référence ;
   la sélection de la première pluralité d'emplacements cibles en tant que sous-ensemble de la troisième pluralité d'emplacements cibles.

8. Procédé selon l'une quelconque revendication précédente, dans lequel, pour chacun de la première pluralité d'emplacements cibles, de l'emplacement cible suivant, de la deuxième pluralité d'emplacements cibles et/ou de la troisième pluralité d'emplacements cibles :

   l'échantillon (S) comprend une ou plusieurs caractéristiques adaptées à un enregistrement d'image à proximité de chaque emplacement cible, de telle sorte qu'une ou plusieurs des caractéristiques sont visibles dans une image obtenue au niveau de l'emplacement cible, et/ou
   chaque emplacement cible est situé à une distance seuil d'un axe optique du microscope, de telle sorte que l'emplacement cible est atteignable par décalage d'image.

9. Procédé selon l'une quelconque revendication précédente, comprenant en outre :

   l'obtention d'une seconde image de référence de l'échantillon (S) au premier grossissement ; et
   l'identification d'une deuxième pluralité d'emplacements cibles dans la seconde image de référence.

10. Procédé selon l'une quelconque revendication précédente, dans lequel le modèle non linéaire est configuré pour estimer un décalage apparent d'une caractéristique de l'échantillon (S) dans une image obtenue en orientant le faisceau électronique (B) vers l'emplacement cible.

11. Procédé selon l'une quelconque revendication précédente, dans lequel l'orientation du faisceau électronique (B) comprend l'ajustement d'une inclinaison et/ou d'un décalage du faisceau électronique (B), de préférence par :

   l'ajustement du faisceau électronique incident (B), et/ou
   l'ajustement du faisceau électronique transmis (B).

12. Procédé selon l'une quelconque revendication précédente, dans lequel l'utilisation de techniques de traitement d'image pour identifier un décalage apparent entre la position attendue de l'emplacement cible dans l'image d'étalonnage et la position observée de l'emplacement cible dans l'image d'étalonnage comprend :

   la détermination de la position attendue de la caractéristique dans l'image d'étalonnage, à l'aide d'un modèle d'orientation ;
   l'identification de la caractéristique dans l'image d'étalonnage au niveau d'une position observée ;
   la détermination du décalage apparent comme étant la différence entre la position attendue et la position observée.

13. Procédé selon l'une quelconque revendication précédente, comprenant en outre :

   l'obtention d'une mesure de défocalisation pour une ou plusieurs images d'étalonnage ; et
   la mise à jour du modèle non linéaire sur la base de la mesure de défocalisation.

14. Appareil de microscope électronique à transmission (M) configuré pour réaliser le procédé selon l'une quelconque des revendications 1 à 13.

15. Logiciel informatique comprenant des instructions qui, lorsqu'elles sont exécutées sur un processeur d'un appareil de microscope électronique à transmission (M), amènent l'appareil de microscope électronique à transmission (M) à réaliser le procédé selon l'une quelconque des revendications 1 à 13.

Figure 1A

Figure 1B

Figure 2A

Figure 2B

Figure 2C

Figure 2D

Figure 3A

Figure 3B

initialize targeting model — S341

acquire grid square image — S342

identify target locations — S343

S344 — more targets available? — No

Yes

S345 — select next target

S346 — targeting model still valid? — Yes

No

S347 — update targeting error model

S348 — apply targeting model to calibrate target

S349 — acquire HM image at calibrated target

measure and store targeting error — S350

S351 — stop data acqusition in current grid square

Figure 3C

the apparent targetting error
vector e = (x' - x, y' - y)

upper obj. lens

correct position (x, y, z )

the real bumpy
sample

ideal flat sample plane, given by the
stage settings, which is tilted by α and
passes through (0, 0, h)

illuminated position (x', y', z')

α

h

x

imaginary targeting plane

(0, 0, 0)

where AFIS assumes
the correct position is

f

lower obj. lens

off-axial coma-free point

Figure 4

Figure 5

(6A)

(6B)

(6C)

Figure 6

Error Vector Field
Mean Arrow Length: 146.462 ± 52.391 nm
Maximum Arrow Length: 271.235 nm

(7A)

Residual Vector Field (EPU Model)
Mean Arrow Length: 51.088 ± 25.866 nm
Maximum Arrow Length: 137.817 nm

(7B)

3D AFIS Prediction Error Vector Field
Mean Arrow Length: 19.939 ± 9.899 nm
Maximum Arrow Length: 50.656 nm

(7C)

Figure 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4101813 A

- US 20210272767 A

**Non-patent literature cited in the description**

- **LIU JINXIN et al.** *Fully Mechanically Controlled Automated Electron Microscopic Tomography" describes*

- **KEVIN M ROCCAPRIORE et al.** *Identification and Correction of Temporal and Spatial Distortions in Scanning Transmission Electron Microscopy*